# EUROPEAN PATENT SPECIFICATION

(11) **EP 4 692 779 B1**
(45) Date of publication and mention of the grant of the patent: **18.11.2026**
(21) Application number: 24784962.3
(22) Date of filing: 04.04.2024
(51) Int. Cl.: G06T 7/00, G06T 7/44, G01N 27/72, G01R 33/10, G01R 33/12

(54) **MAGNETIC DOMAIN STRUCTURE ANALYZING DEVICE, MAGNETIC DOMAIN STRUCTURE ANALYZING METHOD, PROGRAM, METHOD OF MANUFACTURING GRAIN-ORIENTED ELECTROMAGNETIC STEEL SHEET, GRAIN-ORIENTED ELECTROMAGNETIC STEEL SHEET, AND IRON CORE**
MAGNETDOMÄNENSTRUKTURANALYSEVORRICHTUNG, MAGNETDOMÄNENSTRUKTURANALYSEVERFAHREN, PROGRAMM, VERFAHREN ZUR HERSTELLUNG EINES KORNORIENTIERTEN ELEKTROMAGNETISCHEN STAHLBLECHS, KORNORIENTIERTES ELEKTROMAGNETISCHES STAHLBLECH UND EISENKERN
DISPOSITIF D'ANALYSE DE STRUCTURE DE DOMAINE MAGNÉTIQUE, PROCÉDÉ D'ANALYSE DE STRUCTURE DE DOMAINE MAGNÉTIQUE, PROGRAMME, PROCÉDÉ DE PRODUCTION DE FEUILLE D'ACIER ÉLECTROMAGNÉTIQUE À GRAINS ORIENTÉS, FEUILLE D'ACIER ÉLECTROMAGNÉTIQUE À GRAINS ORIENTÉS ET NOYAU DE FER

(30) Priority: 06.04.2023 JP 2023062398
(43) Date of publication of application: 11.02.2026
(73) Proprietor: NIPPON STEEL CORPORATION, Tokyo 100-8071 (JP)
(72) Inventor: KONNO, Yusuke, Tokyo 100-8071 (JP); KAWAMURA, Yusuke, Tokyo 100-8071 (JP)
(74) Representative: Vossius & Partner Patentanwälte Rechtsanwälte mbB
(86) International application number: PCT/JP2024/013970
(87) International publication number: WO 2024/210180

(56) References cited:
- EP-A1- 3 605 072
- JP-A- 2018 124 265
- JP-A- 2019 078 640
- JP-A- 2021 169 655
- JP-A- 2021 169 655
- JP-B1- 6 358 351
- US-A1- 2003 081 215
- JEFFREY MCCORD: "Progress in magnetic domain observation by advanced magneto-optical microscopy", JOURNAL OF PHYSICS D: APPLIED PHYSICS INSTITUTE OF PHYSICS PUBLISHING, BRISTOL, GB, vol. 48, no. 33, 16 July 2015 (2015-07-16), pages 333001, XP020287784, ISSN: 0022-3727, [retrieved on 20150716], DOI: 10.1088/0022-3727/48/33/333001

## Description

### Technical Field

The present disclosure relates to a magnetic domain structure analyzing device, a magnetic domain structure analyzing method, a program, a method of manufacturing a grain-oriented electromagnetic steel sheet, a grain-oriented electromagnetic steel sheet, and an iron core.

### Background Art

It is known that the width of a magnetic domain of a grain-oriented electromagnetic steel sheet is correlated with iron loss at the time when grain-oriented electromagnetic steel sheets are stacked as a transformer. Therefore, determining the distribution of the widths of magnetic domains is important in manufacturing grain-oriented electromagnetic steel sheets.

For example, the following technique is known as a method of visualizing the magnetic domain structure of a grain-oriented electromagnetic steel sheet. Namely, Japanese Patent No. 5987610 discloses a technique that, by using magneto-optical elements that convert the magnetic domain structure into optical characteristics that can be detected as optical characteristics, acquires a magnetic domain image, which shows the magnetic domain structure, on the basis of the optical characteristics detected by the magneto-optical elements.

Further, the following technique is known as a method of investigating the statistical properties of the magnetic domain structure of a grain-oriented electromagnetic steel sheet. Namely, Japanese Patent Application Laid-Open (JP-A) No. 2021-169979 discloses a technique of acquiring plural partial Fourier images by carrying out Fourier transformation on plural partial regions included in a magnetic domain image, and deriving the width and the orientation of a magnetic domain on the basis of the peak positions of spots of the respective partial Fourier images.

Japanese Patent Application JP 2021 169655 discloses analysis method of magnetic domain structure of grain-oriented electrical steel sheet.

### SUMMARY OF INVENTION

### Technical Problem

However, there are the following problems when Fourier transformation is used at the time of deriving the width of a magnetic domain on the basis of a magnetic domain image. Namely, in a case in which the window width of the Fourier transform (i.e., the size of the Fourier transform) is not an integer multiple of the width of the magnetic domain, the peaks of the spectrum scatter, and an accurate peak value cannot be determined. Further, in the Fourier transform, the spectra are at a unform interval on the frequency axis, but are at a non-uniform interval when viewed by wavelength, and therefore, the detection resolution of the width of a magnetic domain deteriorates especially at places where widths of magnetic domains are large.

The present disclosure was made in view of the above-described circumstances, and an object thereof is to provide a magnetic domain structure analyzing device, a magnetic domain structure analyzing method and a program that can accurately measure the width of a magnetic domain as compared with a case using Fourier transformation. Further, an object of the present disclosure is to provide a method of manufacturing a grain-oriented electromagnetic steel sheet that can obtain a grain-oriented electromagnetic steel sheet in which the waveform distortion of the magnetostriction is small while iron loss is effectively reduced. Moreover, an object of the present disclosure is to provide a grain-oriented electromagnetic steel sheet and an iron core in which the waveform distortion of the magnetostriction is small while iron loss is effectively reduced.

### Solution to Problem

A first aspect of the present disclosure is a magnetic domain structure analyzing device including: a magnetic domain image acquiring section acquiring a magnetic domain image by imaging a grain-oriented electromagnetic steel sheet; and a magnetic domain width measuring section measuring a width of a magnetic domain of the grain-oriented electromagnetic steel sheet on the basis of the magnetic domain image, wherein the magnetic domain width measuring section generates plural filter kernels of different spatial sizes by multiplying a complex one-dimensional Gabor filter by A in a spatial direction corresponding to a direction orthogonal to a rolling direction of the grain-oriented electromagnetic steel sheet, and by 1/A in an amplitude direction, applies the plural filter kernels respectively to the magnetic domain image, and calculates an absolute value of filter output per filter kernel, and derives the width of the magnetic domain of the grain-oriented electromagnetic steel sheet on the basis of the spatial size of the filter kernel whose absolute value is largest among the plural filter kernels.

A second aspect of the present disclosure is a magnetic domain structure analyzing device in which the magnetic domain structure analyzing device relating to the first aspect includes a magnetic domain orientation measuring section measuring orientation of a magnetic domain of the grain-oriented electromagnetic steel sheet on the basis of the magnetic domain image, wherein the magnetic domain orientation measuring section generates plural sets of differentiated filter kernels by differentiating two-dimensional Gaussian functions of different spatial sizes in an X direction that corresponds to the direction orthogonal to the rolling direction of the grain-oriented electromagnetic steel sheet and in a Y direction that corresponds to the rolling direction of the grain-oriented electromagnetic steel sheet, for each of the two-dimensional Gaussian functions, applies the plural sets of differentiated filter kernels respectively to the magnetic domain image, and calculates square roots of sums of squares of respective filter outputs of the differentiated filter kernels of the plural sets, and derives the orientation of the magnetic domain of the grain-oriented electromagnetic steel sheet on the basis of the respective filter outputs of the differentiated filter kernels of the set having a largest square root of the sum of squares, among the plural sets of differentiated filter kernels.

A third aspect of the present disclosure is a magnetic domain structure analyzing device in which the magnetic domain structure analyzing device relating to the second aspect includes a magnetic domain width correcting section correcting the width of the magnetic domain of the grain-oriented electromagnetic steel sheet that was measured by the magnetic domain width measuring section, on the basis of the orientation of the magnetic domain of the grain-oriented electromagnetic steel sheet that was measured by the magnetic domain orientation measuring section.

A fourth aspect of the present disclosure is a magnetic domain structure analyzing method including: a magnetic domain image acquiring step of acquiring a magnetic domain image by imaging a grain-oriented electromagnetic steel sheet; and a magnetic domain width measuring step of measuring a width of a magnetic domain on the basis of the magnetic domain image, wherein the magnetic domain width measuring step generates plural filter kernels of different spatial sizes by multiplying a complex one-dimensional Gabor filter by A in a spatial direction corresponding to a direction orthogonal to a rolling direction of the grain-oriented electromagnetic steel sheet, and by 1/A in an amplitude direction, applies the plural filter kernels respectively to the magnetic domain image, and calculates an absolute value of filter output per filter kernel, and derives the width of the magnetic domain of the grain-oriented electromagnetic steel sheet on the basis of the spatial size of the filter kernel whose absolute value is largest among the plural filter kernels.

A fifth aspect of the present disclosure is a magnetic domain structure analyzing method in which the magnetic domain structure analyzing method relating to the fourth aspect includes a magnetic domain orientation measuring step of measuring orientation of a magnetic domain of the grain-oriented electromagnetic steel sheet on the basis of the magnetic domain image, wherein the magnetic domain orientation measuring step generates plural sets of differentiated filter kernels by differentiating two-dimensional Gaussian functions of different spatial sizes in an X direction that corresponds to the direction orthogonal to the rolling direction of the grain-oriented electromagnetic steel sheet and in a Y direction that corresponds to the rolling direction of the grain-oriented electromagnetic steel sheet, for each of the two-dimensional Gaussian functions, applies the plural sets of differentiated filter kernels respectively to the magnetic domain image, and calculates square roots of sums of squares of respective filter outputs of the differentiated filter kernels of the plural sets, and derives the orientation of the magnetic domain of the grain-oriented electromagnetic steel sheet on the basis of the respective filter outputs of the differentiated filter kernels of the set having a largest square root of the sum of squares, among the plural sets of differentiated filter kernels.

A sixth aspect of the present disclosure is a magnetic domain structure analyzing method in which the magnetic domain structure analyzing method relating to the fifth aspect includes a magnetic domain width correcting step of correcting the width of the magnetic domain of the grain-oriented electromagnetic steel sheet that was measured by the magnetic domain width measuring step, on the basis of the orientation of the magnetic domain of the grain-oriented electromagnetic steel sheet that was measured by the magnetic domain orientation measuring step.

A seventh aspect of the present disclosure is a program for causing a computer to execute processings, the processings including: a magnetic domain image acquiring step of acquiring a magnetic domain image by imaging a grain-oriented electromagnetic steel sheet; and a magnetic domain width measuring step of measuring a width of a magnetic domain on the basis of the magnetic domain image, wherein the magnetic domain width measuring step generates plural filter kernels of different spatial sizes by multiplying a complex one-dimensional Gabor filter by A in a spatial direction corresponding to a direction orthogonal to a rolling direction of the grain-oriented electromagnetic steel sheet, and by 1/A in an amplitude direction, applies the plural filter kernels respectively to the magnetic domain image, and calculates an absolute value of filter output per filter kernel, and derives the width of the magnetic domain of the grain-oriented electromagnetic steel sheet on the basis of the spatial size of the filter kernel whose absolute value is largest among the plural filter kernels.

An eighth aspect of the present disclosure is a program in which, in the program relating to the seventh aspect, the processings include a magnetic domain orientation measuring step of measuring orientation of a magnetic domain of the grain-oriented electromagnetic steel sheet on the basis of the magnetic domain image, wherein the magnetic domain orientation measuring step generates plural sets of differentiated filter kernels by differentiating two-dimensional Gaussian functions of different spatial sizes in an X direction that corresponds to the direction orthogonal to the rolling direction of the grain-oriented electromagnetic steel sheet and in a Y direction that corresponds to the rolling direction of the grain-oriented electromagnetic steel sheet, for each of the two-dimensional Gaussian functions, applies the plural sets of differentiated filter kernels respectively to the magnetic domain image, and calculates square roots of sums of squares of respective filter outputs of the differentiated filter kernels of the plural sets, and derives the orientation of the magnetic domain of the grain-oriented electromagnetic steel sheet on the basis of the respective filter outputs of the differentiated filter kernels of the set having a largest square root of the sum of squares, among the plural sets of differentiated filter kernels.

A ninth aspect of the present disclosure is a program in which, in the program relating to the eighth aspect, the processings include a magnetic domain width correcting step of correcting the width of the magnetic domain of the grain-oriented electromagnetic steel sheet that was measured by the magnetic domain width measuring step, on the basis of the orientation of the magnetic domain of the grain-oriented electromagnetic steel sheet that was measured by the magnetic domain orientation measuring step.

A tenth aspect of the present disclosure is a method of manufacturing a grain-oriented electromagnetic steel sheet including: a magnetic domain structure analyzing step of carrying out magnetic domain structure analysis including derivation of a width of a magnetic domain of a grain-oriented electromagnetic steel sheet by using the magnetic domain structure analyzing method of any one of the fourth aspect through the sixth aspect; and a groove or thermal strain forming step of, on the basis of results of analysis obtained by the magnetic domain structure analyzing step, irradiating a laser beam onto a surface of the grain-oriented electromagnetic steel sheet that is being conveyed in a conveying direction, and thereby forming plural grooves or thermal strains, which extend in a direction intersecting the conveying direction, at an interval in the conveying direction.

An eleventh aspect of the present disclosure is a method of manufacturing a grain-oriented electromagnetic steel sheet in which, in the method of manufacturing a grain-oriented electromagnetic steel sheet relating to the tenth aspect, in a case in which the surface of the grain-oriented electromagnetic steel sheet is divided into a first region in which width W of a magnetic domain is threshold value L or more and a second region in which the width W of the magnetic domain is less than the threshold value L, the groove or thermal strain forming step includes forming plural grooves or thermal strains in the first region on the basis of the results of analysis obtained by the magnetic domain structure analyzing step, and, given that a set length that is a total of ideal lengths of each one of the plural grooves or thermal strains formed in the first region is C, a length that is a total of differences between lengths and ideal lengths of each one of, among the plural grooves or thermal strains, grooves or thermal strains at which a length of each one thereof is shorter than a width in a direction parallel to a laser beam irradiating direction of the first region at positions of the respective grooves or thermal strains is D, a length that is a total of differences between lengths and ideal lengths of each one of, among the plural grooves or thermal strains, grooves or thermal strains at which a length of each one thereof is longer than a width in a direction parallel to the laser beam irradiating direction of the first region at positions of the respective grooves or thermal strains is E, and an allowable length proportion corresponding to the set length C of the plural grooves or thermal strains is R, in the groove or thermal strain forming step, the plural grooves or thermal strains that satisfy following formula (1) are formed in the first region by controlling the laser beam on the basis of the results of analysis.$\left(D+E\right) / C < R$ (1)

A twelfth aspect of the present disclosure is a grain-oriented electromagnetic steel sheet, wherein the grain-oriented electromagnetic steel sheet is manufactured by the method of manufacturing a grain-oriented electromagnetic steel sheet of the tenth aspect, and, in a case in which a surface of the grain-oriented electromagnetic steel sheet is divided into a first region in which width W of a magnetic domain of the grain-oriented electromagnetic steel sheet is threshold value L or more and a second region in which the width W of the magnetic domain of the grain-oriented electromagnetic steel sheet is less than the threshold value L, the surface of the grain-oriented electromagnetic steel sheet includes plural grooves or thermal strains formed in the first region, and, given that a set length that is a total of ideal lengths of each one of the plural grooves or thermal strains formed in the first region is C, a length that is a total of differences between lengths and ideal lengths of each one of, among the plural grooves or thermal strains, grooves or thermal strains at which a length of each one thereof is shorter than a width in a direction parallel to a laser beam irradiating direction of the first region at positions of the respective grooves or thermal strains is D, a length that is a total of differences between lengths and ideal lengths of each one of, among the plural grooves or thermal strains, grooves or thermal strains at which a length of each one thereof is longer than a width in a direction parallel to the laser beam irradiating direction of the first region at positions of the respective grooves or thermal strains is E, and an allowable length proportion corresponding to the set length C of the plural grooves or thermal strains is R, the plural grooves or thermal strains that satisfy following formula (1) are formed in the first region. $\left(D+E\right) / C < R$ (1)

A thirteenth aspect of the present disclosure is an iron core manufactured by using the grain-oriented electromagnetic steel sheet relating to the twelfth aspect.

### Advantageous Effects of Invention

In accordance with the present disclosure, there are provided a magnetic domain structure analyzing device, a magnetic domain structure analyzing method and a program that can accurately measure the width of a magnetic domain as compared with a case using Fourier transformation. Further, in accordance with the present disclosure, there is provided a method of manufacturing a grain-oriented electromagnetic steel sheet that can obtain a grain-oriented electromagnetic steel sheet in which the waveform distortion of the magnetostriction is small while iron loss is effectively reduced. Moreover, in accordance with the present disclosure, there are provided a grain-oriented electromagnetic steel sheet and an iron core in which the waveform distortion of the magnetostriction is small while iron loss is effectively reduced.

### BRIEF DESCRIPTION OF DRAWINGS

Fig. 1 is a block drawing illustrating functional structures of a magnetic domain structure analyzing device relating to an embodiment of the present disclosure.
Fig. 2 is an explanatory drawing that explains contents of processing of a magnetic domain width measuring section relating to the embodiment of the present disclosure.
Fig. 3 is an explanatory drawing that explains contents of processing of a magnetic domain orientation measuring section relating to the embodiment of the present disclosure.
Fig. 4 is a drawing illustrating an example of the width of a magnetic domain that has been corrected by a magnetic domain width correcting section relating to the embodiment of the present disclosure.
Fig. 5 is a block drawing illustrating hardware structures of the magnetic domain structure analyzing device relating to the embodiment of the present disclosure.
Fig. 6 is a flowchart illustrating the flow of a magnetic domain structure analyzing method relating to an embodiment of the present disclosure.
Fig. 7 is a drawing illustrating examples of a magnetic domain image, a magnetic domain structure analysis image relating to an Example, and a magnetic domain structure analysis image relating to a Comparative Example.
Fig. 8 is a graph illustrating an example of test results using an artificial image.
Fig. 9 is a drawing illustrating an example of a waveform of a master kernel.
Fig. 10 is a drawing illustrating an example of a method of manufacturing a grain-oriented electromagnetic steel sheet relating to an embodiment of the present disclosure.
Fig. 11 is a drawing comparing a case in which a groove or thermal strain forming step is carried out on the basis of results of analysis obtained by the magnetic domain structure analyzing method relating to the embodiment of the present disclosure, and a case in which a groove or thermal strain forming step is carried out on the basis of results of analysis relating to the Comparative Example.

### DESCRIPTION OF EMBODIMENTS

Embodiments of the present disclosure are described hereinafter.

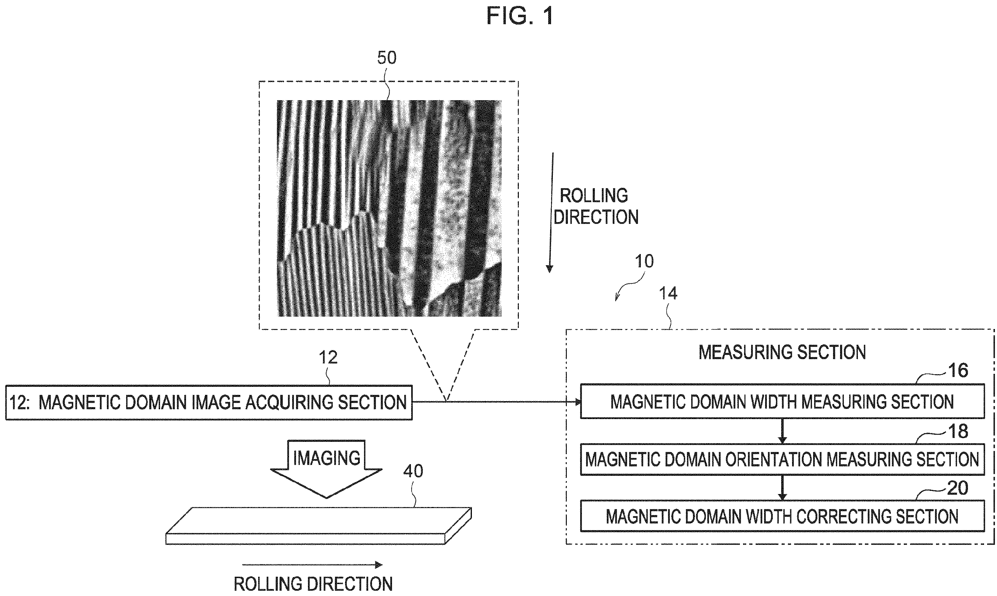

Fig. 1 is a block drawing illustrating structures of a magnetic domain structure analyzing device 10 relating to an embodiment of the present disclosure. The magnetic domain structure analyzing device 10 is a device that acquires a magnetic domain image 50 showing the magnetic domain structure of a grain-oriented electromagnetic steel sheet 40, and measures the width and orientation of a magnetic domain on the basis of the acquired magnetic domain image 50. The magnetic domain structure analyzing device 10 has a magnetic domain image acquiring section 12 and a measuring section 14.

The magnetic domain image acquiring section 12 is an imaging device that acquires the magnetic domain image 50 by imaging the grain-oriented electromagnetic steel sheet 40. Provided that it is an imaging device that can acquire the magnetic domain image 50, the magnetic domain image acquiring section 12 may be any type of imaging device such as, for example, a visualizing device having magneto-optical elements, a scanning electron microscope, or an electromagnetic microscope. The magnetic domain image 50 is an image having a black-and-white striped pattern corresponding to the azimuths of the magnetic domains. What is called magnetic domain here is a 180° magnetic domain. In the magnetic domain image 50, the widths of the stripes correspond to the widths of the magnetic domains, and the directions in which the stripes extend correspond to the orientations of the magnetic domains. The vertical direction of the magnetic domain image 50 is approximately parallel to the rolling direction of the grain-oriented electromagnetic steel sheet 40, and the horizontal direction of the magnetic domain image 50 is approximately orthogonal to the rolling direction. Hereinafter, the rolling direction of the grain-oriented electromagnetic steel sheet 40 will be called the Y direction, and the direction orthogonal to the rolling direction will be called the X direction.

The measuring section 14 has a magnetic domain width measuring section 16, a magnetic domain orientation measuring section 18, and a magnetic domain width correcting section 20. The measuring section 14 is realized by, for example, a computer that is equipped with a CPU (Central Processing Unit), a storage device, a memory and the like. Due to the CPU executing a program that is stored in the storage device by using the memory as a workspace, the CPU functions as the magnetic domain width measuring section 16, the magnetic domain orientation measuring section 18, and the magnetic domain width correcting section 20.

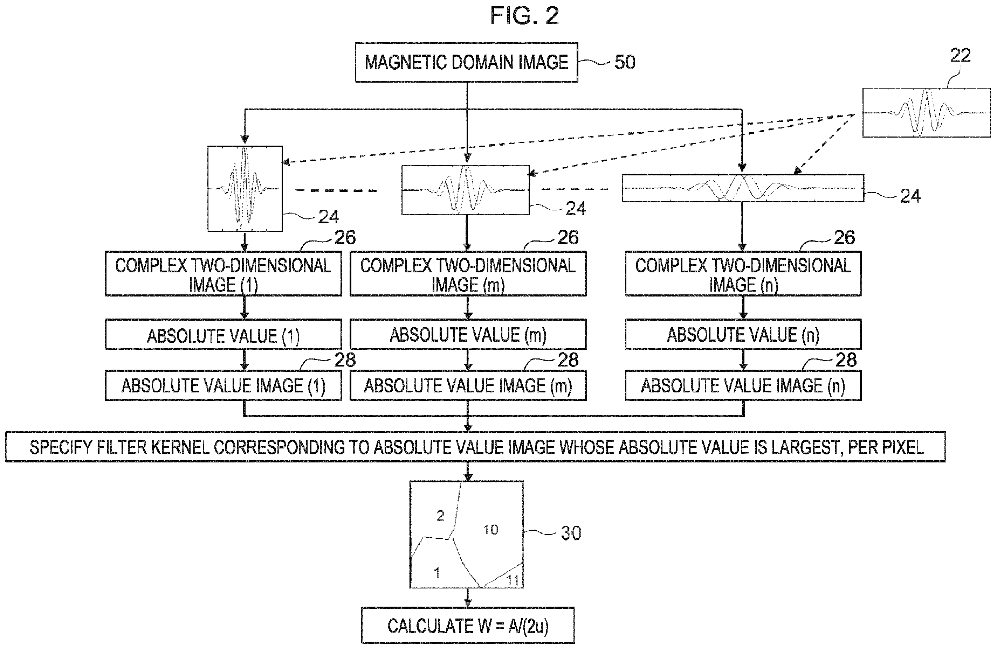

The magnetic domain width measuring section 16 measures the width of a magnetic domain of the grain-oriented electromagnetic steel sheet 40 on the basis of the magnetic domain image 50 acquired by the magnetic domain image acquiring section 12. Fig. 2 is an explanatory drawing that explains contents of the processings of the magnetic domain width measuring section 16 relating to an embodiment of the present disclosure. First, due to the magnetic domain width measuring section 16 setting parameters σ and u to predetermined values in the formula of the complex one-dimensional Gabor filter expressed by the following formula (1), the magnetic domain width measuring section 16 sets one master kernel 22 that is the filter kernel that is the reference. Here, σ is a parameter that prescribes the spread of the filter kernel in the spatial direction, and u is a parameter that sets the central frequency (central wavelength) of the filter kernel. Further, x is the coordinate value in the X direction. The setting method that sets parameters σ and u to predetermined values is described later. The reason why the filter kernel is made to be a complex number is because, in a case in which the magnetic domain image 50 is viewed as sine wave-shaped light and shade, both the sine component and the cosine component at an arbitrary x coordinate position must be detected. $exp \left(-\frac{{x}^{2}}{{σ}^{2}}\right) exp \left(2πiux\right)$ (1)

Next, as shown by the following formula (2), the magnetic domain width measuring section 16 generates plural filter kernels 24 (n filter kernels 24) of different spatial sizes, by multiplying the master kernel 22 by A in the spatial direction corresponding to the direction orthogonal to the rolling direction of the grain-oriented electromagnetic steel sheet 40, and by 1/A in the amplitude direction. Here, A is a number greater than 0, and this A is called the scale factor. The plural filter kernels 24 that are structured in this way have bandpass filter characteristics of respectively different central frequencies, but the peak gains thereof are the same. Namely, the output amplitudes, in a case in which a sine wave matching the central frequency of the filter is inputted, are the same. It is desirable for there to be an arithmetic progression such that the A's that respectively correspond to the plural filter kernels 24 are at a uniform interval on the spatial axis. $\frac{1}{A} exp \left(-\frac{{x}^{2}}{{\left(Aσ\right)}^{2}}\right) exp \left(2πiux/A\right)$ (2)

Next, the magnetic domain width measuring section 16 generates plural complex two-dimensional images 26 (n complex two-dimensional images 26) by directing the respective filter kernels 24, which have a spread in the function in the X direction, in the horizontal direction of the magnetic domain image 50 (the direction corresponding to the direction orthogonal to the rolling direction of the grain-oriented electromagnetic steel sheet 40, the direction corresponding to the direction orthogonal to the extending direction of the magnetic domain), and applying the respective filter kernels 24 to the brightness values of the magnetic domain image 50. In this case, the magnetic domain width measuring section 16 applies the respective filter kernels 24 to all of the pixels of the magnetic domain image 50. The complex two-dimensional images 26 are images of the same size as the magnetic domain image 50.

Next, the magnetic domain width measuring section 16 calculates absolute value B of the filter output for each pixel of each of the complex two-dimensional images 26 by using following formula (3). Here, Re represents the real part of the complex two-dimensional image 26, and Im represents the imaginary part of the complex two-dimensional image 26.

The filter kernel 24 that has a specific central frequency is applied to the magnetic domain image 50 that has black/white brightness values that differ per magnetic domain. Therefore, the central frequency of the filter kernel 24 whose absolute value B is the maximum is the nearest to the frequency of the striped pattern formed by the magnetic domains in the magnetic domain image 50. Namely, the central frequency of the bandpass filter expressed by formula (2) is (u/A) (unit: 1/pixel), and the wavelength is (A/u) (unit: pixel). In the magnetic domain image 50, given that a pair of a white portion and a black portion is one wavelength, in a case in which the widths of the white portion and the black portion are the same, the absolute value B of the filter kernel 24 becomes a maximum when the magnetic domain width is A/(2u). $B = \sqrt{{Re}^{2} + {Im}^{2}}$ (3)

Next, the magnetic domain width measuring section 16 generates, per filter kernel 24, an absolute value image 28 that shows the absolute value B of each pixel. Due thereto, the plural absolute value images 28 (n absolute value images 28) are obtained. The absolute value images 28 are images of the same size as the magnetic domain image 50. Then, by comparing the plural absolute value images 28, the magnetic domain width measuring section 16 specifies the filter kernel 24 that corresponds to the absolute value image 28 whose absolute value B is the largest, per pixel (i.e., per same coordinate). Due thereto, for each pixel, the filter kernel 24 whose spatial size is most suited to the width of the stripe is specified from among the plural filter kernels 24.

Next, the magnetic domain width measuring section 16 generates a scale factor distribution image 30 showing the distribution of the scale factors A corresponding to the filter kernel 24 specified per pixel. Fig. 2 illustrates an example of the scale factor distribution image 30 that shows the distribution of the scale factors A of the filter kernels 24 whose absolute values B are the maximums (the scale factor distribution image 30 that is divided into a sectional image per value of the scale factor A, due to the scale factors A being different).

Then, for each pixel of the scale factor distribution image 30, the magnetic domain width measuring section 16 derives the width W of the magnetic domain. Specifically, the magnetic domain width measuring section 16 derives width W of the magnetic domain by the following formula (4). By the above procedures, the magnetic domain width measuring section 16 measures the width of the magnetic domain on the basis of the magnetic domain image acquired by the magnetic domain image acquiring section 12. $W = A / \left(2u\right)$ (4)

Next, an example of the setting method that sets parameters σ and u of the master kernel 22 to predetermined values is described. First, on the basis of the range of the width of the magnetic domain that is to be measured, and the magnification at the time of acquiring the magnetic domain image, and the like, the range (whose unit is number of pixels) of the width of the stripe, which corresponds to the range of the width of the magnetic domain that is to be measured, is derived. Then, parameters σ and u are set such that the filter kernel 24, in which the absolute value B becomes the largest for the derived range of the width of the stripe, is included. For example, at the master kernel 22 of a case in which the number of pixels corresponding to the width of the stripes is 10 pixels, the central wavelength is 20 pixels, and accordingly, the central frequency is 1/20 (unit: 1/pixels), and therefore u = 1/20.

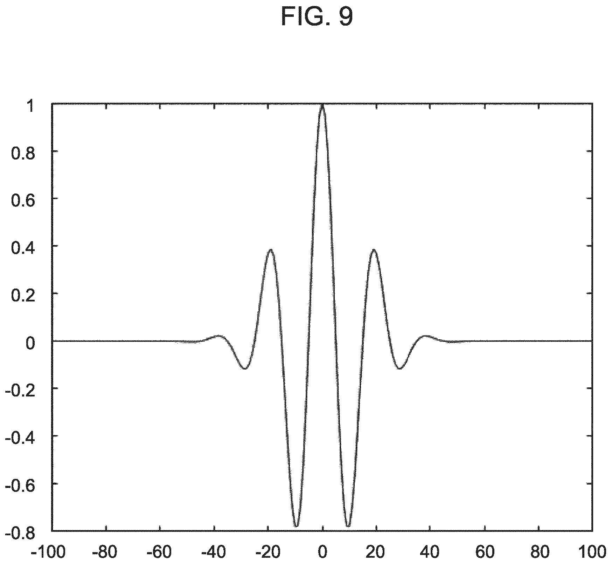

Further, because the master kernel must have a length that is greater than or equal to the lowest one wavelength, it is preferable that σ, with respect to u = 1/20, be 20 pixels or more, and the master kernel is expressed by the following formula (5) for example. Further, the master kernel expressed by formula (5) is a waveform such as illustrated in Fig. 9. The master kernel 22 is generated by the magnetic domain width measuring section 16 by the above-described procedures. $exp \left(\frac{iπx}{10}\right) exp \left(-{\left(\frac{x}{20}\right)}^{2}\right)$ (5)

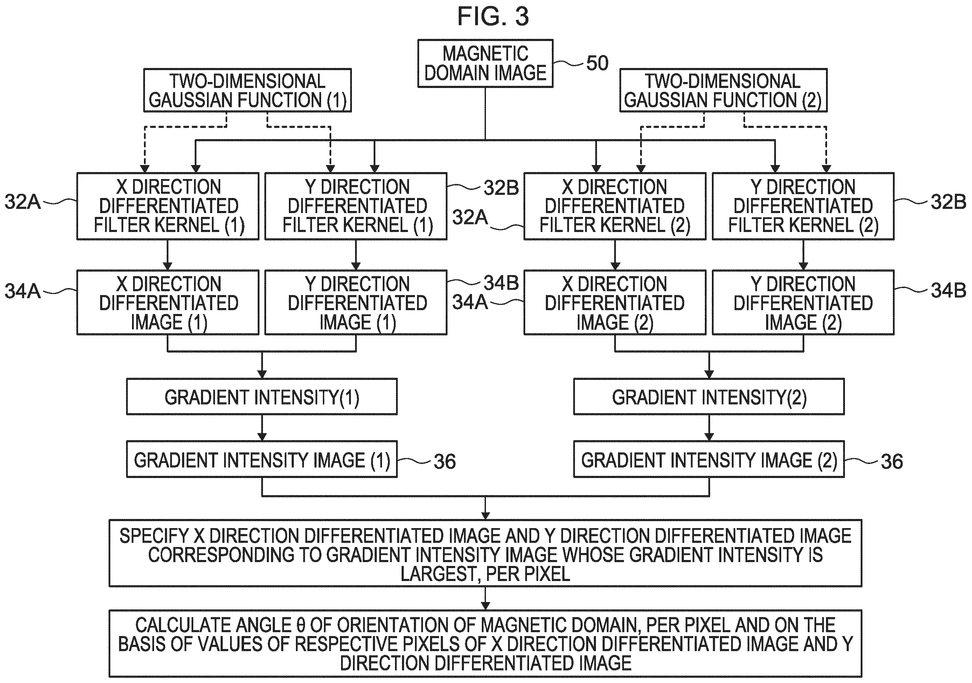

The magnetic domain orientation measuring section 18 measures the orientation of a magnetic domain of the grain-oriented electromagnetic steel sheet 40 on the basis of the magnetic domain image 50 acquired by the magnetic domain image acquiring section 12. Fig. 3 is an explanatory drawing that explains contents of the processings of the magnetic domain orientation measuring section 18 relating to an embodiment of the present disclosure. First, the magnetic domain orientation measuring section 18 changes parameter ρ in the two-dimensional Gaussian function expressed by the following formula (6), and generates plural two-dimensional Gaussian functions that have the same volumes and different spatial sizes. Here, x is the coordinate value in the X direction, and y is the coordinate value in the Y direction. The setting method of parameter ρ in this case may be the same as or may be different than the above-described method of setting σ at the magnetic domain width measuring section 16. Note that the maximum value of parameter ρ is preferably larger than the maximum width of the stripes. Fig. 3 illustrates two two-dimensional Gaussian functions as an example of the plural two-dimensional Gaussian functions. $\frac{1}{2 {πρ}^{2}} exp \left(-\frac{{x}^{2} + {y}^{2}}{2 {ρ}^{2}}\right)$ (6)

Next, by differentiating the respective two-dimensional Gaussian functions in the X direction and the Y direction, the magnetic domain orientation measuring section 18 generates an X direction differentiated filter kernel 32A and a Y direction differentiated filter kernel 32B. Due thereto, the X direction differentiated filter kernel 32A and the Y direction differentiated filter kernel 32B are obtained for each of the two-dimensional Gaussian functions that have different spatial sizes. In Fig. 3, two sets of the X direction differentiated filter kernel 32A and Y direction differentiated filter kernel 32B are illustrated as an example of the plural sets of differentiated filter kernels.

Next, the magnetic domain orientation measuring section 18 generates X direction differentiated images 34A in which the respective X direction differentiated filter kernels 32A have been applied to the magnetic domain image 50, and Y direction differentiated images 34B in which the respective Y direction differentiated filter kernels 32B have been applied to the magnetic domain image 50. In this case, the magnetic domain orientation measuring section 18 applies the respective X direction differentiated filter kernels 32A and the respective Y direction differentiated filter kernels 32B to all of the pixels of the magnetic domain image 50. In Fig. 3, two sets of the X direction differentiated images 34A and Y direction differentiated images 34B are illustrated as an example of the plural sets of differentiated images.

Next, by the following formula (7), the magnetic domain orientation measuring section 18 obtains gradient intensity G(ρ) for each pixel of each set of the X direction differentiated image 34A and Y direction differentiated image 34B. Here, Rx(ρ) represents the value of each pixel of the X direction differentiated image 34A, and Ry(p) represents the value of each pixel of the Y direction differentiated image 34B. Rx(ρ) corresponds to the filter output of the X direction differentiated filter kernel 32A corresponding to each parameter ρ, and Ry(p) corresponds to the filter output of the Y direction differentiated filter kernel 32B corresponding to each parameter ρ. Further, the gradient intensity G(ρ) corresponds to the square root of the sum of squares of the respective filter outputs of the X direction differentiated filter kernel 32A and the Y direction differentiated filter kernel 32B. In a case in which the spread of the Gaussian function of formula (6) is the size of a black/white pair of stripes, i.e., is around two times the magnetic domain width, the gradient intensity of formula (7) is the largest. Therefore, [Rx(ρ), Ry(ρ)] that corresponds to the ρ at which the gradient intensity G(ρ) is the largest is the vector of the direction orthogonal to the stripes. For example, in a case in which the stripes are parallel to the rolling direction, Ry(p) is zero, and there is only the value of Rx(ρ). $G \left(ρ\right) = \sqrt{{\left(Rx\left(ρ\right)\right)}^{2} + {\left(Ry\left(ρ\right)\right)}^{2}}$ (7)

Next, the magnetic domain orientation measuring section 18 generates a gradient intensity image 36 that shows the gradient intensity per pixel, for each set of the X direction differentiated filter kernel 32A and Y direction differentiated filter kernel 32B. Plural gradient intensity images 36 are thereby obtained. In Fig. 3, two of the gradient intensity images 36 are illustrated as an example of the plural gradient intensity images 36.

Next, by comparing the plural gradient intensity images 36, the magnetic domain orientation measuring section 18 specifies ρ, which corresponds to the gradient intensity image 36 whose gradient intensity is the largest, for each pixel (i.e., for each same coordinate).

Then, on the basis of the values of the respective pixels of the specified X direction differentiated image 34A and Y direction differentiated image 34B, the magnetic domain orientation measuring section 18 calculates, per pixel, angle θ of the orientation of the magnetic domain by the following formula (8). The angle θ of the orientation of the magnetic domain corresponds to the smaller angle of the angles formed by the direction orthogonal to the rolling direction and the orientation of the magnetic domain. By the above procedures, the magnetic domain orientation measuring section 18 measures the orientation of the magnetic domain on the basis of the magnetic domain image acquired by the magnetic domain image acquiring section 12. $θ = atan \left(Ry\left(ρ\right)/Rx\left(ρ\right)\right) + π / 2$ (8)

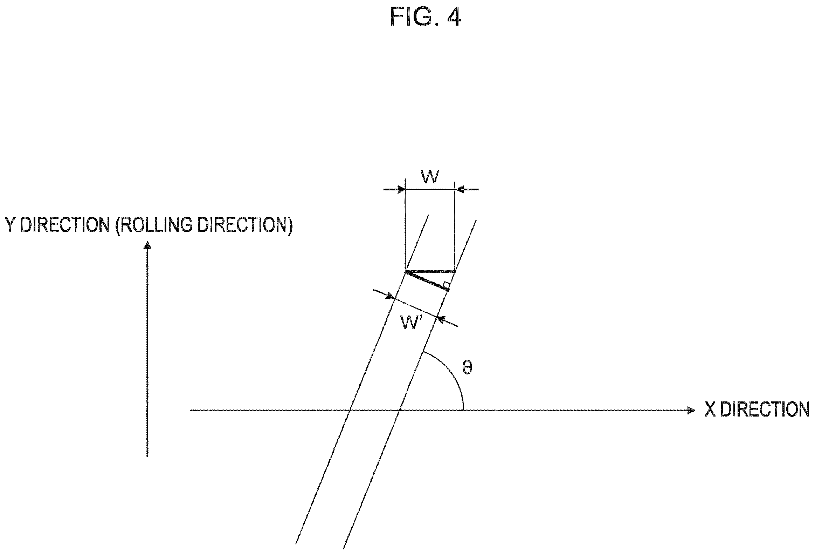

The magnetic domain width correcting section 20 corrects the width W of the magnetic domain that was measured by the magnetic domain width measuring section 16, on the basis of the orientation of the magnetic domain that was measured by the magnetic domain orientation measuring section 18. Due thereto, corrected width W' of the magnetic domain is obtained. Fig. 4 is a drawing illustrating an example of the width W' of the magnetic domain that has been corrected by the magnetic domain width correcting section 20 relating to an embodiment of the present disclosure. As illustrated in Fig. 4, width W of the magnetic domain that is measured by the magnetic domain width measuring section 16 is the width along the direction (i.e., the horizontal direction of the magnetic domain image 50) orthogonal to the rolling direction. Accordingly, in a case in which the orientation of the magnetic domain is not parallel to the rolling direction, a width that is larger than the width in the direction orthogonal to the orientation of the magnetic domain is measured by the magnetic domain width measuring section 16, and an error arises between the width of the magnetic domain measured by the magnetic domain width measuring section 16 and the width in the direction orthogonal to the orientation of the magnetic domain (i.e., the width of the magnetic domain that is desired to be obtained actually).

Here, the magnetic domain width correcting section 20 calculates the width W' in the direction orthogonal to the orientation of the magnetic domain by the following formula (9) and on the basis of the width W of the magnetic domain measured by the magnetic domain width measuring section 16 and the angle θ of the orientation of the magnetic domain measured by the magnetic domain orientation measuring section 18. By the above procedures, the magnetic domain width correcting section 20 corrects the width W of the magnetic domain measured by the magnetic domain width measuring section 16, on the basis of the orientation of the magnetic domain measured by the magnetic domain orientation measuring section 18. $W ′ = W \times sinθ$ (9)

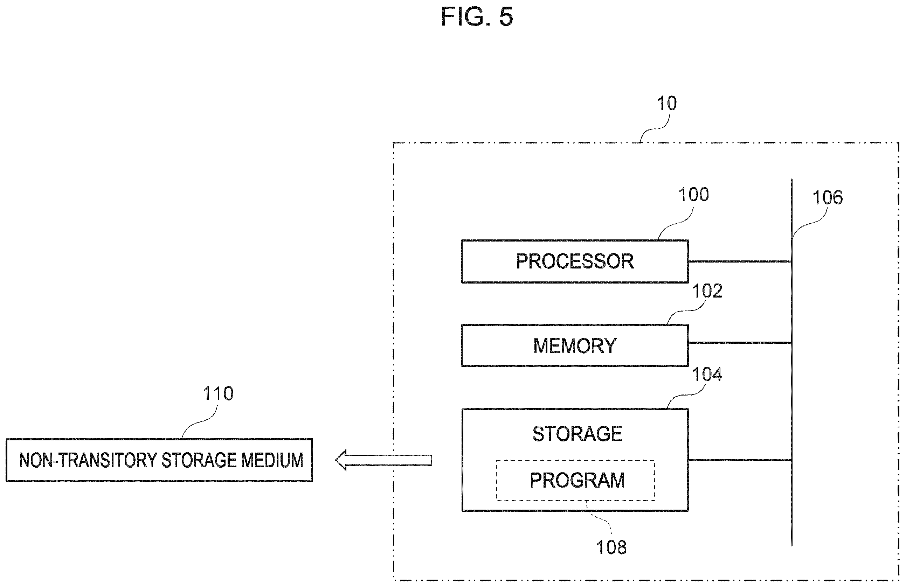

Fig. 5 is a block drawing illustrating hardware structures of the magnetic domain structure analyzing device 10 relating to the embodiment of the present disclosure. As illustrated in Fig. 5, the magnetic domain structure analyzing device 10 is structured by a computer. The magnetic domain structure analyzing device 10 has, as hardware, a processor 100, a memory 102 and a storage 104. The processor 100, the memory 102 and the storage 104 are connected so as to be able to communicate with one another via bus 106.

The processor 100 has a CPU (Central Processing Unit) or the like. The memory 102 has a ROM (Read Only Memory) and a RAM (Random Access Memory) or the like. The ROM stores various programs and various data. The RAM temporarily stores programs or data as a workspace. The storage 104 is structured by an HDD (Hard Disk Drive) or an SSD (Solid State Drive) or the like, and stores various programs, including the operating system, and various data.

A program 108 for analyzing the structure of a magnetic domain is stored in the storage 104. The processor 100 reads-out the program 108 and executes the program 108 by using the RAM as a workspace. The above-described magnetic domain width measuring section 16, magnetic domain orientation measuring section 18 and magnetic domain width correcting section 20 (see Fig. 1) are realized by the processor 100 executing the program 108.

Note that the processor 100 may include a dedicated-use processor such as a GPU (Graphics Processing Unit), an ASIC (Application Specific Integrated Circuit), an FPGA (Field Programmable Gate Array), or the like. Further, the processor 100 may be structured by one processor, or may be structured by plural processors. The program 108 may be stored on a computer-readable, non-transitory storage medium 110.

A magnetic domain structure analyzing method relating to an embodiment of the present disclosure is described next.

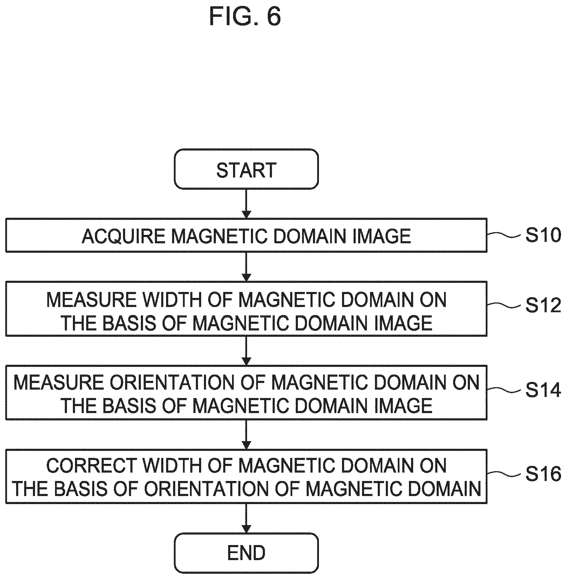

Fig. 6 is a flowchart illustrating the flow of the magnetic domain structure analyzing method relating to the embodiment of the present disclosure. The magnetic domain structure analyzing method is executed by the above-described magnetic domain structure analyzing device 10. When the magnetic domain structure analyzing method is started, first, in step S10, the magnetic domain image acquiring section 12 acquires the magnetic domain image 50 by imaging the grain-oriented electromagnetic steel sheet 40. Then, the magnetic domain structure analyzing device 10 acquires the magnetic domain image 50 acquired by the magnetic domain image acquiring section 12. Step S10 is an example of the magnetic domain image acquiring step.

Next, in step S12, the magnetic domain width measuring section 16 measures the width W of the magnetic domain on the basis of the magnetic domain image 50 acquired by the magnetic domain image acquiring section 12. Step S12 is an example of the magnetic domain width measuring step.

Next, in step S14, the magnetic domain orientation measuring section 18 measures the orientation of the magnetic domain on the basis of the magnetic domain image 50 acquired by the magnetic domain image acquiring section 12. Step S14 is an example of the magnetic domain orientation measuring step.

Next, in step S16, the magnetic domain width correcting section 20 corrects the width W of the magnetic domain that was measured by the magnetic domain width measuring section 16, on the basis of the orientation of the magnetic domain that was measured by the magnetic domain orientation measuring section 18. Due thereto, corrected width W' of the magnetic domain is obtained. Step S16 is an example of the magnetic domain width correcting step. Then, the magnetic domain structure analyzing method ends.

Effects of the embodiment of the present disclosure are described next.

As described above, in the magnetic domain structure analyzing device 10, the magnetic domain width measuring section 16 generates the plural filter kernels 24 of different spatial sizes, by multiplying a complex one-dimensional Gabor filter by A in the spatial direction corresponding to the direction orthogonal to the rolling direction of the grain-oriented electromagnetic steel sheet 40, and by 1/A in the amplitude direction. Next, the magnetic domain width measuring section 16 calculates the absolute value B of the filter output per filter kernel 24, by applying the plural filter kernels 24 respectively to the magnetic domain image 50. Then, the magnetic domain width measuring section 16 derives the width W of a magnetic domain of the grain-oriented electromagnetic steel sheet 40 on the basis of the spatial size of the filter whose absolute value B is the largest among the plural filter kernels 24. Accordingly, because the width W of the magnetic domain can be measured without using Fourier transformation, all of the problems of cases of measuring the width W of a magnetic domain by using Fourier transformation can be avoided. Due thereto, the width W of a magnetic domain can be measured accurately as compared with a case of measuring the width W of a magnetic domain by using Fourier transformation.

Further, the magnetic domain orientation measuring section 18 generates plural sets of the X direction differentiated filter kernel 32A and the Y direction differentiated filter kernel 32B by differentiating two-dimensional Gaussian functions, which have different spatial sizes, in the X direction that corresponds to the direction orthogonal to the rolling direction of the grain-oriented electromagnetic steel sheet 40 and in the Y direction that corresponds to the rolling direction, per two-dimensional Gaussian function. Next, by respectively applying, to the magnetic domain image 50, the plural sets of the X direction differentiated filter kernel 32A and the Y direction differentiated filter kernel 32B, the magnetic domain orientation measuring section 18 derives the square roots of the sums of squares of the respective filter outputs of the X direction differentiated filter kernels 32A and the Y direction differentiated filter kernels 32B of the plural sets. Then, the magnetic domain orientation measuring section 18 derives the orientation of a magnetic domain of the grain-oriented electromagnetic steel sheet 40 on the basis of the respective filter outputs of the set of the X direction differentiated filter kernel 32A and the Y direction differentiated filter kernel 32B that has the largest square root of the sum of squares, among the plural sets of the X direction differentiated filter kernel 32A and the Y direction differentiated filter kernel 32B. Accordingly, because the orientation of a magnetic domain can be measured without using Fourier transformation, all of the problems of cases of measuring the orientation of a magnetic domain by using Fourier transformation can be avoided. Due thereto, the orientation of a magnetic domain can be measured accurately as compared with a case of measuring the orientation of a magnetic domain by using Fourier transformation.

Further, the magnetic domain width correcting section 20 corrects the width W of the magnetic domain that was measured by the magnetic domain width measuring section 16, on the basis of the orientation of the magnetic domain that was measured by the magnetic domain orientation measuring section 18. Specifically, the magnetic domain width correcting section 20 derives the width W' in the direction orthogonal to the orientation of the magnetic domain, on the basis of the width W of the magnetic domain measured by the magnetic domain width measuring section 16 and the angle θ of the orientation of the magnetic domain measured by the magnetic domain orientation measuring section 18. Due thereto, as compared with a case in which the orientation of the magnetic domain is not parallel to the rolling direction, and the width W of the magnetic domain measured by the magnetic domain width measuring section 16 is treated as is as the width of the magnetic domain, a highly accurate width of a magnetic domain (i.e., the width of the magnetic domain that is desired to be obtained actually) can be obtained.

By the way, in the present embodiment, a complex one-dimensional Gabor filter is used in order to measure the width of the magnetic domain. However, instead of a complex one-dimensional Gabor filter, use of a two-dimensional Gabor filter that can measure the width and the orientation of a magnetic domain is contemplated. However, because the orientation of the magnetic domain usually is substantially parallel to the rolling direction, there is no need to expressly use a two-dimensional Gabor filter in order to determine the width and the orientation of a magnetic domain. Accordingly, by using a complex one-dimensional Gabor filter as in the present embodiment, the processing load of the processor 100 can be reduced as compared with a case of using a two-dimensional Gabor filter.

An Example is described next.

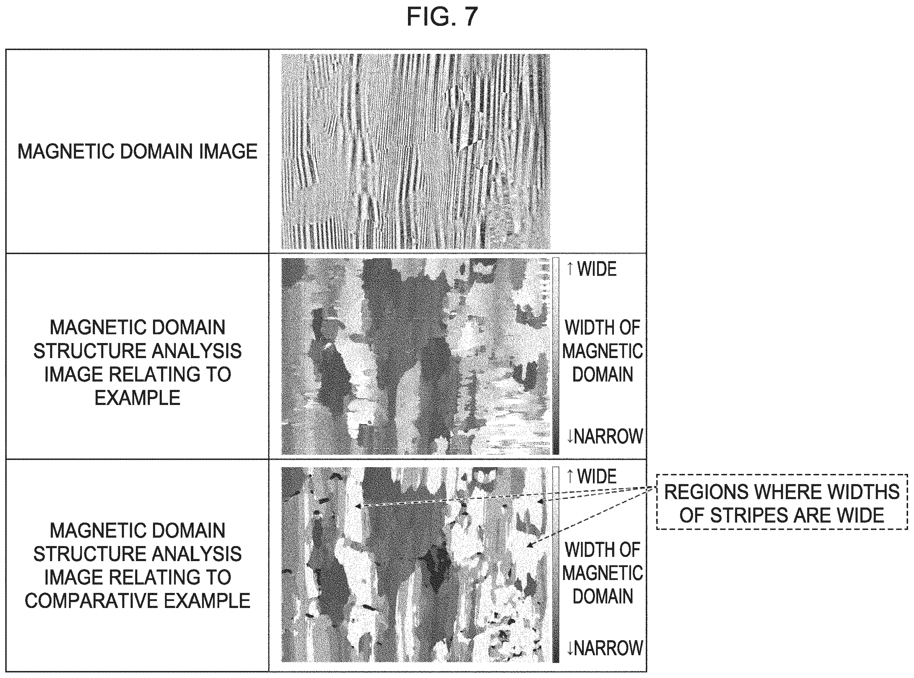

Fig. 7 is a drawing illustrating examples of a magnetic domain image, a magnetic domain structure analysis image relating to an Example, and a magnetic domain structure analysis image relating to a Comparative Example. The magnetic domain image is an image acquired by the magnetic domain image acquiring section 12. The magnetic domain structure analysis image relating to the Example is an image generated from the magnetic domain image by using the magnetic domain structure analyzing device 10 relating to the present embodiment, and is an image showing, per pixel, the width of the magnetic domain corrected by the magnetic domain width correcting section 20. The magnetic domain structure analysis image relating to the Comparative Example is an image generated from the magnetic domain image by using Fourier transformation, and is an image showing, per pixel, the width of the magnetic domain derived by using Fourier transformation. In the magnetic domain structure analysis image relating to the Example and the magnetic domain structure analysis image relating to the Comparative Example, the lightness/darkness of the pixels shows the breadths of the widths of the magnetic domains.

In the magnetic domain structure analysis image relating to the Example, widths of the magnetic domains that correspond to the widths of the stripes of the magnetic domain image are obtained. In contrast, in the magnetic domain structure analysis image relating to the Comparative Example, in regions where the widths of the stripes are broad, widths of the magnetic domains that correspond to the widths of the stripes are not obtained. It is assumed that the cause thereof is that the detection resolution is insufficient in regions where the widths of the stripes are broad.

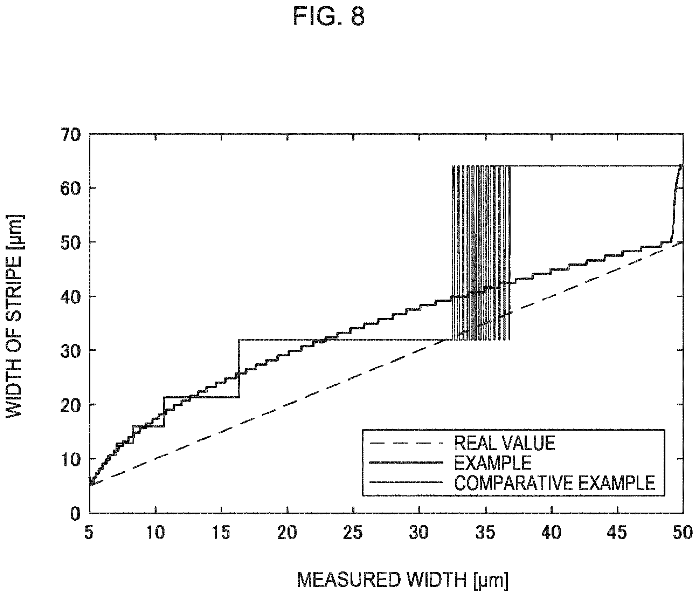

Fig. 8 is a graph illustrating an example of results of testing using an artificial image. The artificial image is an image in which the widths of the black/white stripes change rectilinearly. The graphed line showing the real values shows the widths of the stripes of the artificial image. The graphed line showing the Example shows the results of measuring the widths of the stripes of the artificial image by using the magnetic domain structure analyzing device relating to the present embodiment. The graphed line showing the Comparative Example shows the results of measuring the widths of the stripes of the artificial image by using Fourier transformation.

In the Example, results of measurement corresponding to the real values are obtained. In contrast, in the Comparative Example, results of measurement corresponding to the real values are not obtained in a partial range of widths of the stripes (as an example, the range in which the widths of the stripes are from 32 µm to 64 µm). It is assumed that the reason for this is that, because the window width of the Fourier transform (i.e., the size of the Fourier transform) is not an integer multiple of the width of the stripes, the peaks of the spectrum scatter, and accurate peak values cannot be determined.

A method of manufacturing a grain-oriented electromagnetic steel sheet relating to a present embodiment is described next.

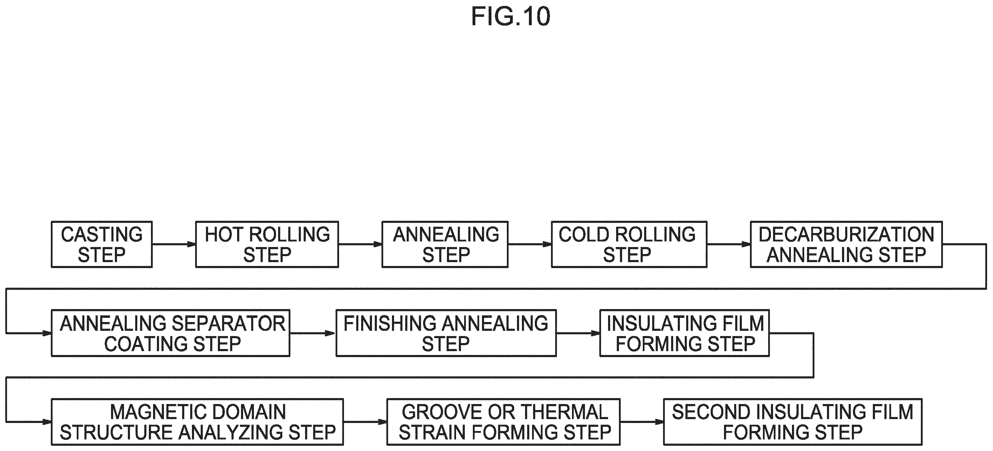

Fig. 10 is a drawing illustrating an example of the method of manufacturing a grain-oriented electromagnetic steel sheet relating to the present embodiment. The method of manufacturing a grain-oriented electromagnetic steel sheet relating to the present embodiment has, as an example, a casting step, a hot rolling step, an annealing step, a cold rolling step, a decarburization annealing step, an annealing separator coating step, a finishing annealing step, an insulating film forming step, a magnetic domain structure analyzing step, a groove or thermal strain forming step, and a second insulating film forming step.

The casting step is a step of producing a slab by a continuous casting method. The hot rolling step is a step of carrying out hot rolling on the slab that has been heated to a predetermined heating temperature (e.g., 1100°C - 1400°C), and obtaining a hot rolled steel sheet. The annealing step is a step of annealing the hot rolled steel sheet instantaneously or for a short time, and obtaining an annealed steel sheet. The cold rolling step is a step of obtaining a cold rolled steel sheet by cold rolling the annealed steel sheet one time, or by cold rolling the annealed steel sheet plural times (e.g., two or more times) via intermediate annealing. The decarburization annealing step is a step of carrying out decarburization annealing on the cold rolled steel sheet and obtaining a decarburization annealed steel sheet in which primary recrystallization has occurred.

The annealing separator coating step is a step of coating an annealing separator agent on the decarburization annealed steel sheet. The finishing annealing step is a step of carrying out finishing annealing on the decarburization annealed steel sheet onto which the annealing separator agent has been coated, and causing secondary recrystallization to take place, and obtaining a finishing annealed steel sheet. Here, finishing annealed steel sheet means the steel sheet in which finishing annealing has been carried out on the decarburization annealed steel sheet onto which the annealing separator agent was coated, and at which secondary recrystallization has occurred. The insulating film forming step is a step of, by coating and baking a coating solution onto the surface of the finishing annealed steel sheet, forming an insulating film on the surface of the finishing annealed steel sheet. The grain-oriented electromagnetic steel sheet 40 illustrated in Fig. 1 corresponds to the finishing annealed steel sheet.

The magnetic domain structure analyzing step is a step of, by using the magnetic domain structure analyzing method relating to the above-described present embodiment, carrying out magnetic domain structure analysis that includes deriving the width of a magnetic domain of the grain-oriented electromagnetic steel sheet (i.e., the width of a magnetic domain measured by the magnetic domain width measuring section 16 or the width of a magnetic domain corrected by the magnetic domain width correcting section 20).

The groove or thermal strain forming step is a step of, on the basis of the results of analysis obtained by the magnetic domain structure analyzing step, irradiating a laser beam onto the surface of the grain-oriented electromagnetic steel sheet that is being conveyed in a conveying direction, and thereby forming plural grooves or thermal strains, which extend in a direction intersecting the conveying direction, at an interval the conveying direction. Note that the conveying direction substantially coincides with the rolling direction in the above-described hot rolling step and cold rolling step. Because the orientations of the magnetic domains are substantially parallel to the rolling direction, the grooves or thermal strains are formed so as to extend in a direction intersecting the magnetic domain orientations.

The second insulating film forming step is a step of, by coating and baking a coating solution onto the surface of the grain-oriented electromagnetic steel sheet in which the plural grooves or thermal strains have been formed, again forming an insulating film on the surface of the grain-oriented electromagnetic steel sheet. A grain-oriented electromagnetic steel sheet is manufactured by the above-described respective processes.

The present inventors first studied, in the magnetic domain structure analyzing step, acquiring plural partial Fourier images by carrying out Fourier transformation on plural partial images included in a magnetic domain image by using Fourier transformation (single-section two-dimensional Fourier transformation), and deriving the width and orientation of a magnetic domain on the basis of the peak value of the spot of each partial Fourier image.

However, the present inventors learned that there are the following problems when using a Fourier transform at the time of deriving the width of a magnetic domain on the basis of a magnetic domain image. Namely, the present inventors learned that, in a case in which the window width of the Fourier transform (i.e., the size of the Fourier transform) is not an integer multiple of the width of the magnetic domain, the peaks of the spectrum scatter, and an accurate peak value cannot be determined. Further, the present inventors learned that, in the Fourier transform, because the spectra are at a unform interval on the frequency axis but are at a non-uniform interval when viewed by wavelength, the detection resolution of the width of a magnetic domain decreases especially at places where the width of the magnetic domain is large. Specifically, the present inventors learned that places where the width W of the magnetic domain is larger than a threshold value L must be determined, but in order to do so, the window of the Fourier transform must be set in a moving section that is 2L at the lowest. Further, the present inventors learned that an error (intermediate value) of ± L/2 arises from the border of the theoretically real value of the Fourier transform. Note that the threshold value L is 500 µm.

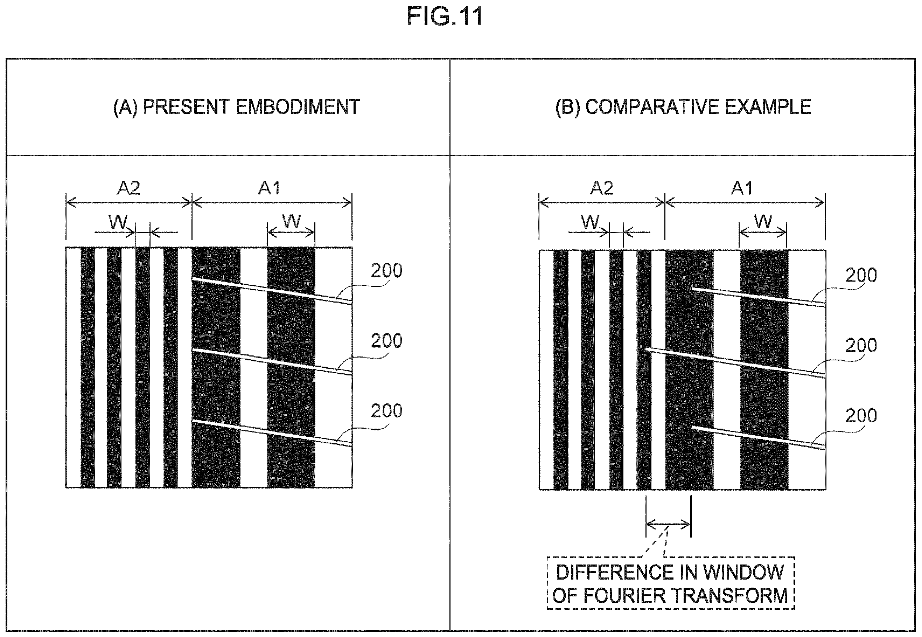

Fig. 11 is a drawing comparing a case in which the groove or thermal strain forming step is carried out on the basis of results of analysis relating to the present embodiment, and a case in which the groove or thermal strain forming step is carried out on the basis of results of analysis relating to the Comparative Example. Fig. 11(A) illustrates a case in which the groove or thermal strain forming step is carried out on the basis of results of analysis obtained by using the magnetic domain structure analyzing method relating to the present embodiment in the magnetic domain structure analyzing step. As the Comparative Example, Fig. 11(B) illustrates a case in which the groove or thermal strain forming step is carried out on the basis of results of analysis obtained by using Fourier transformation in the magnetic domain structure analyzing step. In a case in which the surface of the grain-oriented electromagnetic steel sheet is divided into a first region A1 in which the width W of the magnetic domain is the threshold value L or greater and a second region A2 in which the width W of the magnetic domain is less than the threshold value L, the groove or thermal strain forming step includes forming plural grooves or thermal strains 200 in the first region A1 on the basis of the results of analysis. Note that, in the present embodiment, a laser beam is irradiated from one end over to the another end in the sheet width direction of the first region A1 (the direction 90°C with respect to the conveying direction or the rolling direction), continuously without pause so as to extend in the one direction.

In accordance with the magnetic domain structure analyzing method relating to the present embodiment, it is possible to identify laser beam irradiated positions of shapes that are close to the laser beam irradiation distribution that is determined from real values. However, in the case of Fourier transformation, grooves or thermal strains that are mis-strikes of the laser beam, or grooves or thermal strains that are excessive strikes by the laser beam, are formed. Grooves or thermal strains that are mis-strikes are grooves or thermal strains at which the length per one thereof is shorter than the width, in the direction parallel to the laser beam irradiating direction, of the first region A1 at the positions of the respective grooves or thermal strains. Grooves or thermal strains that are excessive strikes by the laser beam are grooves or thermal strains at which the length per one thereof is longer than the width, in the direction parallel to the laser beam irradiating direction, of the first region A1 at the positions of the respective grooves or thermal strains.

When the groove or thermal strain forming step is carried out on the basis of the results of analysis relating to the present embodiment, the following grain-oriented electromagnetic steel sheet can be manufactured. Namely, a grain-oriented electromagnetic steel sheet, at which plural grooves or thermal strains 200 that satisfy following formula (10) are formed in the first region A1, can be manufactured by controlling the laser beam in the groove or thermal strain forming step on the basis of the results of analysis relating to the present embodiment, given that a set length that is the total of the ideal lengths of each one of the plural grooves or thermal strains 200 formed in the first region A1 is C, and that the length that is the total of the differences between the lengths and the ideal lengths of each one of, among the plural grooves or thermal strains 200, the grooves or thermal strains at which the length of each one thereof is shorter than the width in a direction parallel to the laser beam irradiating direction of the first region A1 at the positions of the respective grooves or thermal strains is D, and that the length that is the total of the differences between the lengths and the ideal lengths of each one of, among the plural grooves or thermal strains 200, the grooves or thermal strains at which the length of each one thereof is longer than the width in a direction parallel to the laser beam irradiating direction of the first region A1 at the positions of the respective grooves or thermal strains is E, and that the allowable proportion corresponding to the set length C of the plural grooves or thermal strains 200 is R. Note that the above-described length C is a value obtained by multiplying the number of laser beams irradiated at the first region A1 (the total number of grooves or thermal strains used in deriving D and E) by the width in the direction parallel to the laser beam irradiating direction of the first region A1.
The lower the value at the left side of formula (10), the lower the rate of mis-strikes of and excessive strikes by the laser beam, and it can be said that the more accurately the laser beam is irradiated onto a selective portion. It suffices for R to be 0.2 for example, and R is preferably 0.1 and more preferably 0.05. $\left(D+E\right) / C < R$ (10)

Note that the grain-oriented electromagnetic steel sheet that is manufactured by the manufacturing method relating to the present embodiment can be specified by the following technique. Namely, the positions where the laser beam was irradiated are identified visually or by magnetic domain observation of the grain-oriented electromagnetic steel sheet that is the target. Next, stress relief annealing (SRA) is carried out on the grain-oriented electromagnetic steel sheet, and the thermal strains due to irradiation of the laser beam are removed. Next, demagnetization is carried out in a predetermined direction. Next, by observing the domain structure by using a magnetic field imaging system and viewing the magnetic domain image with the naked eye, the grain-oriented electromagnetic steel sheet is divided into the first region A1 that is the portion where the width of the magnetic domain (the width in the direction orthogonal to the magnetic domain walls) is the threshold value L or more, and the second region A2 where the width is less than the threshold value L. Next, it is judged whether or not formula (10) is satisfied. The grain-oriented electromagnetic steel sheet that is manufactured by the manufacturing method relating to the present embodiment can be specified by such a technique.

As described in detail above, in accordance with the method of manufacturing a grain-oriented electromagnetic steel sheet relating to the present embodiment, as compared with the Comparative Example, a laser beam can be irradiated more accurately onto selective portions, and therefore, a grain-oriented electromagnetic steel sheet in which the waveform distortion of the magnetostriction is small while iron loss is effectively reduced, can be obtained.

An Example of the method of manufacturing a grain-oriented electromagnetic steel sheet relating to the present embodiment is described next.
A grain-oriented electromagnetic steel sheet of a sample size of 100 mm × 100 mm was collected from the iron core of a transformer or from a coil in a shape that was such that mechanical strain of a wire cutter or the like was not included therein.

The judgment as to the irradiated positions of the laser beam was carried out by visually confirming the surface of the grain-oriented electromagnetic steel sheet. In cases in which judgement could not be made visually, the surface of the grain-oriented electromagnetic steel sheet was confirmed by using a magnetic field imaging system. In cases in which judgement could not clearly be made even by a magnetic field imaging system, the surface of the grain-oriented electromagnetic steel sheet was confirmed while applying a magnetic field in the direction orthogonal to the sheet surface.
Stress relief annealing (SRA) was carried out by carrying out annealing in which the grain-oriented electromagnetic steel sheet was 250 maintained at 850°C, and was cooled to 200°C at an average cooling rate of 20°C/h, and thereafter, was cooled to 50°C at an average cooling rate of 100°C/h.

With regard to the timing of the demagnetization and the observation of the magnetic domain structure, a magnetic domain image was captured at a time that was 30 seconds after attenuation of the magnetic flux density was started, in accordance with formula (11). $B = 1.9 {e}^{- 0.3 t} cos 0.70 πt$ (11) Here, B is the magnetic flux density (T), and t is time (sec).

In the present Example, a grain-oriented electromagnetic steel sheet in which the plural grooves or thermal strains 200 satisfying above formula (10) were formed in the first region A1 could be manufactured.

Although embodiments of the present disclosure have been described above, the present disclosure is not limited to the above, and can, of course, be implemented by being modified in various ways other than the above within a scope that does not depart from the gist thereof.

### Explanation of Reference Numerals

- 10: magnetic domain structure analyzing device
- 12: magnetic domain image acquiring section
- 14: measuring section
- 16: magnetic domain width measuring section
- 18: magnetic domain orientation measuring section
- 20: magnetic domain width correcting section
- 22: master kernel
- 24: filter kernel
- 26: complex two-dimensional image
- 28: absolute value image
- 30: scale factor distribution image
- 32A: X direction differentiated filter kernel
- 32B: Y direction differentiated filter kernel
- 34A: X direction differentiated image
- 34B: Y direction differentiated image
- 36: gradient intensity image
- 40: grain-oriented electromagnetic steel sheet
- 50: magnetic domain image
- 100: processor
- 102: memory
- 104: storage
- 106: bus
- 108: program
- 110: non-transitory storage medium
- 200: groove or thermal strain

## Claims

1. A magnetic domain structure analyzing device (10) comprising:
a magnetic domain image acquiring section (12) acquiring a magnetic domain image (50) by imaging a grain-oriented electromagnetic steel sheet; sheet (40); and
a magnetic domain width measuring section (16) measuring a width of a magnetic domain of the grain-oriented electromagnetic steel sheet on the basis of the magnetic domain image,
wherein the magnetic domain width measuring section
generates a plurality of filter kernels (24) of different spatial sizes by multiplying a complex one-dimensional Gabor filter by A in a spatial direction corresponding to a direction orthogonal to a rolling direction of the grain-oriented electromagnetic steel sheet, and by 1/A in an amplitude direction,
applies the plurality of filter kernels respectively to the magnetic domain image, and calculates an absolute value of filter output (28) per filter kernel, and
derives the width of the magnetic domain of the grain-oriented electromagnetic steel sheet on the basis of the spatial size of the filter kernel whose absolute value is largest among the plurality of filter kernels.

2. The magnetic domain structure analyzing device of Claim 1, comprising a magnetic domain orientation measuring section measuring orientation of a magnetic domain of the grain-oriented electromagnetic steel sheet on the basis of the magnetic domain image,
wherein the magnetic domain orientation measuring section
generates a plurality of sets of differentiated filter kernels by differentiating two-dimensional Gaussian functions of different spatial sizes in an X direction that corresponds to the direction orthogonal to the rolling direction of the grain-oriented electromagnetic steel sheet and in a Y direction that corresponds to the rolling direction of the grain-oriented electromagnetic steel sheet, for each of the two-dimensional Gaussian functions,
applies the plurality of sets of differentiated filter kernels respectively to the magnetic domain image, and calculates square roots of sums of squares of respective filter outputs of the differentiated filter kernels of the plurality of sets, and
derives the orientation of the magnetic domain of the grain-oriented electromagnetic steel sheet on the basis of the respective filter outputs of the differentiated filter kernels of the set having a largest square root of the sum of squares, among the plurality of sets of differentiated filter kernels.

3. The magnetic domain structure analyzing device of Claim 2, comprising a magnetic domain width correcting section correcting the width of the magnetic domain of the grain-oriented electromagnetic steel sheet that was measured by the magnetic domain width measuring section, on the basis of the orientation of the magnetic domain of the grain-oriented electromagnetic steel sheet that was measured by the magnetic domain orientation measuring section.

4. A magnetic domain structure analyzing method comprising:
a magnetic domain image acquiring step of acquiring a magnetic domain image by imaging a grain-oriented electromagnetic steel sheet; and
a magnetic domain width measuring step of measuring a width of a magnetic domain on the basis of the magnetic domain image,
wherein the magnetic domain width measuring step
generates a plurality of filter kernels of different spatial sizes by multiplying a complex one-dimensional Gabor filter by A in a spatial direction corresponding to a direction orthogonal to a rolling direction of the grain-oriented electromagnetic steel sheet, and by 1/A in an amplitude direction,
applies the plurality of filter kernels respectively to the magnetic domain image, and calculates an absolute value of filter output per filter kernel, and
derives the width of the magnetic domain of the grain-oriented electromagnetic steel sheet on the basis of the spatial size of the filter kernel whose absolute value is largest among the plurality of filter kernels.

5. The magnetic domain structure analyzing method of Claim 4, comprising a magnetic domain orientation measuring step of measuring orientation of a magnetic domain of the grain-oriented electromagnetic steel sheet on the basis of the magnetic domain image,
wherein the magnetic domain orientation measuring step
generates a plurality of sets of differentiated filter kernels by differentiating two-dimensional Gaussian functions of different spatial sizes in an X direction that corresponds to the direction orthogonal to the rolling direction of the grain-oriented electromagnetic steel sheet and in a Y direction that corresponds to the rolling direction of the grain-oriented electromagnetic steel sheet, for each of the two-dimensional Gaussian functions,
applies the plurality of sets of differentiated filter kernels respectively to the magnetic domain image, and calculates square roots of sums of squares of respective filter outputs of the differentiated filter kernels of the plurality of sets, and
derives the orientation of the magnetic domain of the grain-oriented electromagnetic steel sheet on the basis of the respective filter outputs of the differentiated filter kernels of the set having a largest square root of the sum of squares, among the plurality of sets of differentiated filter kernels.

6. The magnetic domain structure analyzing method of Claim 5, comprising a magnetic domain width correcting step of correcting the width of the magnetic domain of the grain-oriented electromagnetic steel sheet that was measured by the magnetic domain width measuring step, on the basis of the orientation of the magnetic domain of the grain-oriented electromagnetic steel sheet that was measured by the magnetic domain orientation measuring step.

7. A program for causing a computer to execute processings, the processings comprising:
a magnetic domain image acquiring step of acquiring a magnetic domain image by imaging a grain-oriented electromagnetic steel sheet; and
a magnetic domain width measuring step of measuring a width of a magnetic domain on the basis of the magnetic domain image,
wherein the magnetic domain width measuring step
generates a plurality of filter kernels of different spatial sizes by multiplying a complex one-dimensional Gabor filter by A in a spatial direction corresponding to a direction orthogonal to a rolling direction of the grain-oriented electromagnetic steel sheet, and by 1/A in an amplitude direction,
applies the plurality of filter kernels respectively to the magnetic domain image, and calculates an absolute value of filter output per filter kernel, and
derives the width of the magnetic domain of the grain-oriented electromagnetic steel sheet on the basis of the spatial size of the filter kernel whose absolute value is largest among the plurality of filter kernels.

8. The program of Claim 7, wherein the processings comprise a magnetic domain orientation measuring step of measuring orientation of a magnetic domain of the grain-oriented electromagnetic steel sheet on the basis of the magnetic domain image,
wherein the magnetic domain orientation measuring step
generates a plurality of sets of differentiated filter kernels by differentiating two-dimensional Gaussian functions of different spatial sizes in an X direction that corresponds to the direction orthogonal to the rolling direction of the grain-oriented electromagnetic steel sheet and in a Y direction that corresponds to the rolling direction of the grain-oriented electromagnetic steel sheet, for each of the two-dimensional Gaussian functions,
applies the plurality of sets of differentiated filter kernels respectively to the magnetic domain image, and calculates square roots of sums of squares of respective filter outputs of the differentiated filter kernels of the plurality of sets, and
derives the orientation of the magnetic domain of the grain-oriented electromagnetic steel sheet on the basis of the respective filter outputs of the differentiated filter kernels of the set having a largest square root of the sum of squares, among the plurality of sets of differentiated filter kernels.

9. The program of Claim 8, wherein the processings comprise a magnetic domain width correcting step of correcting the width of the magnetic domain of the grain-oriented electromagnetic steel sheet that was measured by the magnetic domain width measuring step, on the basis of the orientation of the magnetic domain of the grain-oriented electromagnetic steel sheet that was measured by the magnetic domain orientation measuring step.

10. A method of manufacturing a grain-oriented electromagnetic steel sheet, comprising:
a magnetic domain structure analyzing step of carrying out magnetic domain structure analysis including derivation of a width of a magnetic domain of a grain-oriented electromagnetic steel sheet by using the magnetic domain structure analyzing method of any one of Claim 4 through Claim 6; and
a groove or thermal strain forming step of, on the basis of results of analysis obtained by the magnetic domain structure analyzing step, irradiating a laser beam onto a surface of the grain-oriented electromagnetic steel sheet that is being conveyed in a conveying direction, and thereby forming a plurality of grooves or thermal strains, which extend in a direction intersecting the conveying direction, at an interval in the conveying direction.

11. The method of manufacturing a grain-oriented electromagnetic steel sheet of Claim 10, wherein,
in a case in which the surface of the grain-oriented electromagnetic steel sheet is divided into a first region in which width W of a magnetic domain is threshold value L or more and a second region in which the width W of the magnetic domain is less than the threshold value L, the groove or thermal strain forming step includes forming a plurality of grooves or thermal strains in the first region on the basis of the results of analysis obtained by the magnetic domain structure analyzing step, and,
given that
a set length that is a total of ideal lengths of each one of the plurality of grooves or thermal strains formed in the first region is C,
a length that is a total of differences between lengths and ideal lengths of each one of, among the plurality of grooves or thermal strains, grooves or thermal strains at which a length of each one thereof is shorter than a width in a direction parallel to a laser beam irradiating direction of the first region at positions of the respective grooves or thermal strains is D,
a length that is a total of differences between lengths and ideal lengths of each one of, among the plurality of grooves or thermal strains, grooves or thermal strains at which a length of each one thereof is longer than a width in a direction parallel to the laser beam irradiating direction of the first region at positions of the respective grooves or thermal strains is E, and
an allowable length proportion corresponding to the set length C of the plurality of grooves or thermal strains is R,
in the groove or thermal strain forming step, the plurality of grooves or thermal strains that satisfy following formula (1) are formed in the first region by controlling the laser beam on the basis of the results of analysis. $\left(D+E\right) / C < R$ (1)

12. A grain-oriented electromagnetic steel sheet, wherein
the grain-oriented electromagnetic steel sheet is manufactured by the method of manufacturing a grain-oriented electromagnetic steel sheet of Claim 10, and,
in a case in which a surface of the grain-oriented electromagnetic steel sheet is divided into a first region in which width W of a magnetic domain of the grain-oriented electromagnetic steel sheet is threshold value L or more and a second region in which the width W of the magnetic domain of the grain-oriented electromagnetic steel sheet is less than the threshold value L, the surface of the grain-oriented electromagnetic steel sheet includes a plurality of grooves or thermal strains formed in the first region, and,
given that
a set length that is a total of ideal lengths of each one of the plurality of grooves or thermal strains formed in the first region is C,
a length that is a total of differences between lengths and ideal lengths of each one of, among the plurality of grooves or thermal strains, grooves or thermal strains at which a length of each one thereof is shorter than a width in a direction parallel to a laser beam irradiating direction of the first region at positions of the respective grooves or thermal strains is D,
a length that is a total of differences between lengths and ideal lengths of each one of, among the plurality of grooves or thermal strains, grooves or thermal strains at which a length of each one thereof is longer than a width in a direction parallel to the laser beam irradiating direction of the first region at positions of the respective grooves or thermal strains is E, and
an allowable length proportion corresponding to the set length C of the plurality of grooves or thermal strains is R,
the plurality of grooves or thermal strains that satisfy following formula (1) are formed in the first region. $\left(D+E\right) / C < R$ (1)

13. An iron core manufactured by using the grain-oriented electromagnetic steel sheet of Claim 12.

## Patentansprüche

1. Vorrichtung (10) zur Analyse einer Struktur magnetischer Domänen, die aufweist:
einen Abschnitt (12) zur Erfassung eines Bildes magnetischer Domänen, der ein Bild (50) magnetischer Domänen durch Abbilden eines kornorientierten elektromagnetischen Stahlblechs (40) erfasst; und
einen Abschnitt (16) zur Messung der Breite magnetischer Domänen, der eine Breite einer magnetischen Domäne des kornorientierten elektromagnetischen Stahlblechs auf der Grundlage des Bildes magnetischer Domänen misst, wobei der Abschnitt zur Messung der Breite magnetischer Domänen
mehrere Filterkerne (24) unterschiedlicher räumlicher Größe durch Multiplizieren eines komplexen eindimensionalen Gabor-Filters mit A in einer räumlichen Richtung, die einer Richtung orthogonal zur Walzrichtung des kornorientierten elektromagnetischen Stahlblechs entspricht, und mit 1/A in einer Amplitudenrichtung erzeugt,
die mehreren Filterkerne jeweils auf das Bild magnetischer Domänen anwendet und einen Absolutwert der Filterausgabe (28) pro Filterkern berechnet, und
die Breite der magnetischen Domäne des kornorientierten elektromagnetischen Stahlblechs auf der Grundlage der räumlichen Größe des Filterkerns ableitet, dessen Absolutwert unter den mehreren Filterkernen am größten ist.

2. Vorrichtung zur Analyse einer Struktur magnetischer Domänen nach Anspruch 1, die einen Abschnitt zur Messung der Orientierung magnetischer Domänen aufweist, der die Orientierung einer magnetischen Domäne des kornorientierten elektromagnetischen Stahlblechs auf der Grundlage des Bildes magnetischer Domänen misst,
wobei der Abschnitt zur Messung der Orientierung magnetischer Domänen
mehrere Sätze differenzierter Filterkerne durch Differenzieren zweidimensionaler Gauß-Funktionen unterschiedlicher räumlicher Größe in einer X-Richtung, die der zur Walzrichtung des kornorientierten elektromagnetischen Stahlblechs orthogonalen Richtung entspricht, und in einer Y-Richtung, die der Walzrichtung des kornorientierten elektromagnetischen Stahlblechs entspricht, für jede der zweidimensionalen Gauß-Funktionen erzeugt,
die mehreren Sätze differenzierter Filterkerne jeweils auf das Bild magnetischer Domänen anwendet und Quadratwurzeln der Quadratsummen der jeweiligen Filterausgaben der differenzierten Filterkerne der mehreren Sätze berechnet, und
die Orientierung der magnetischen Domäne des kornorientierten elektromagnetischen Stahlblechs auf der Grundlage der jeweiligen Filterausgaben der differenzierten Filterkerne des Satzes mit der größten Quadratwurzel der Summe der Quadrate unter den mehreren Sätzen differenzierter Filterkerne ableitet.

3. Vorrichtung zur Analyse einer Struktur magnetischer Domänen nach Anspruch 2, die einen Abschnitt zur Korrektur der Breite magnetischer Domänen aufweist, der die Breite der magnetischen Domäne des kornorientierten elektromagnetischen Stahlblechs, die vom Abschnitt zur Messung der Breite magnetischer Domänen gemessen wurde, auf der Grundlage der Orientierung der magnetischen Domäne des kornorientierten elektromagnetischen Stahlblechs korrigiert, die vom Abschnitt zur Messung der Orientierung magnetischer Domänen gemessen wurde.

4. Verfahren zur Analyse einer Struktur magnetischer Domänen, das aufweist:
einen Schritt zum Erfassen eines Bildes magnetischer Domänen durch Abbilden eines kornorientierten elektromagnetischen Stahlblechs; und
einen Schritt zum Messen der Breite einer magnetischen Domäne auf der Grundlage des Bildes magnetischer Domänen,
wobei der Schritt zum Messen der Breite magnetischer Domänen
mehrere Filterkerne unterschiedlicher räumlicher Größe durch Multiplizieren eines komplexen eindimensionalen Gabor-Filters mit A in einer räumlichen Richtung, die einer Richtung orthogonal zur Walzrichtung des kornorientierten elektromagnetischen Stahlblechs entspricht, und mit 1/A in einer Amplitudenrichtung erzeugt,
die mehreren Filterkerne jeweils auf das Bild magnetischer Domänen anwendet und einen Absolutwert der Filterausgabe pro Filterkern berechnet, und
die Breite der magnetischen Domäne des kornorientierten elektromagnetischen Stahlblechs auf der Grundlage der räumlichen Größe des Filterkerns ableitet, dessen Absolutwert unter den mehreren Filterkernen am größten ist.

5. Verfahren zur Analyse einer Struktur magnetischer Domänen nach Anspruch 4, das einen Schritt zum Messen der Orientierung magnetischer Domänen zum Messen der Orientierung einer magnetischen Domäne des kornorientierten elektromagnetischen Stahlblechs auf der Grundlage des Bildes magnetischer Domänen aufweist,
wobei der Schritt zum Messen der Orientierung magnetischer Domänen
mehrere Sätze differenzierter Filterkerne durch Differenzieren zweidimensionaler Gauß-Funktionen unterschiedlicher räumlicher Größe in einer X-Richtung, die der zur Walzrichtung des kornorientierten elektromagnetischen Stahlblechs orthogonalen Richtung entspricht, und in einer Y-Richtung, die der Walzrichtung des kornorientierten elektromagnetischen Stahlblechs entspricht, für jede der zweidimensionalen Gauß-Funktionen erzeugt,
die mehreren Sätze differenzierter Filterkerne jeweils auf das Bild magnetischer Domänen anwendet und Quadratwurzeln der Quadratsummen der jeweiligen Filterausgaben der differenzierten Filterkerne der mehreren Sätze berechnet, und
die Orientierung der magnetischen Domäne des kornorientierten elektromagnetischen Stahlblechs auf der Grundlage der jeweiligen Filterausgaben der differenzierten Filterkerne des Satzes mit der größten Quadratwurzel der Summe der Quadrate unter den mehreren Sätzen differenzierter Filterkerne ableitet.

6. Verfahren zur Analyse einer Struktur magnetischer Domänen nach Anspruch 5, das einen Schritt zum Korrigieren der Breite magnetischer Domänen zum Korrigieren der Breite der magnetischen Domäne des kornorientierten elektromagnetischen Stahlblechs, die durch den Schritt zum Messen der Breite magnetischer Domänen gemessen wurde, auf der Grundlage der Orientierung der magnetischen Domäne des kornorientierten elektromagnetischen Stahlblechs aufweist, die durch den Schritt zum Messen der Orientierung magnetischer Domänen gemessen wurde.

7. Programm, das einen Computer dazu veranlasst, Verarbeitungsabläufe auszuführen, wobei die Verarbeitungsabläufe aufweisen:
einen Schritt zum Erfassen eines Bildes magnetischer Domänen durch Abbilden eines kornorientierten elektromagnetischen Stahlblechs; und
einen Schritt zum Messen der Breite einer magnetischen Domäne auf der Grundlage des Bildes magnetischer Domänen,
wobei der Schritt zum Messen der Breite magnetischer Domänen mehrere Filterkerne unterschiedlicher räumlicher Größe durch Multiplizieren eines komplexen eindimensionalen Gabor-Filters mit A in einer räumlichen Richtung, die einer Richtung orthogonal zur Walzrichtung des kornorientierten elektromagnetischen Stahlblechs entspricht, und mit 1/A in einer Amplitudenrichtung erzeugt,
die mehreren Filterkerne jeweils auf das Bild magnetischer Domänen anwendet und einen Absolutwert der Filterausgabe pro Filterkern berechnet, und
die Breite der magnetischen Domäne des kornorientierten elektromagnetischen Stahlblechs auf der Grundlage der räumlichen Größe des Filterkerns ableitet, dessen Absolutwert unter den mehreren Filterkernen am größten ist.

8. Programm nach Anspruch 7, wobei die Verarbeitungsabläufe einen Schritt zum Messen der Orientierung magnetischer Domänen zum Messen der Orientierung einer magnetischen Domäne des kornorientierten elektromagnetischen Stahlblechs auf der Grundlage des Bildes magnetischer Domänen aufweisen,
wobei der Schritt zum Messen der Orientierung magnetischer Domänen
mehrere Sätze differenzierter Filterkerne durch Differenzieren zweidimensionaler Gauß-Funktionen unterschiedlicher räumlicher Größe in einer X-Richtung, die der zur Walzrichtung des kornorientierten elektromagnetischen Stahlblechs orthogonalen Richtung entspricht, und in einer Y-Richtung, die der Walzrichtung des kornorientierten elektromagnetischen Stahlblechs entspricht, für jede der zweidimensionalen Gauß-Funktionen erzeugt,
die mehreren Sätze differenzierter Filterkerne jeweils auf das Bild magnetischer Domänen anwendet und Quadratwurzeln der Quadratsummen der jeweiligen Filterausgaben der differenzierten Filterkerne der mehreren Sätze berechnet, und
die Orientierung der magnetischen Domäne des kornorientierten elektromagnetischen Stahlblechs auf der Grundlage der jeweiligen Filterausgaben der differenzierten Filterkerne des Satzes mit der größten Quadratwurzel der Summe der Quadrate unter den mehreren Sätzen differenzierter Filterkerne ableitet.

9. Programm nach Anspruch 8, wobei die Verarbeitungsabläufe einen Schritt zum Korrigieren der Breite magnetischer Domänen zum Korrigieren der Breite der magnetischen Domäne des kornorientierten elektromagnetischen Stahlblechs, die durch den Schritt zum Messen der Breite magnetischer Domänen gemessen wurde, auf der Grundlage der Orientierung der magnetischen Domäne des kornorientierten elektromagnetischen Stahlblechs aufweisen, die durch den Schritt zum Messen der Orientierung magnetischer Domänen gemessen wurde.

10. Verfahren zur Herstellung eines kornorientierten elektromagnetischen Stahlblechs, das aufweist:
einen Schritt zur Analyse einer Struktur magnetischer Domänen, in dem unter Verwendung des Verfahrens zur Analyse einer Struktur magnetischer Domänen nach einem der Ansprüche 4 bis 6 eine Analyse einer Struktur magnetischer Domänen durch geführt wird, die das Ableiten einer Breite einer magnetischen Domäne des kornorientierten elektromagnetischen Stahlblechs aufweist; und
einen Schritt zum Bilden von Rillen oder thermischen Dehnungen, in dem auf der Grundlage der durch den Schritt zur Analyse einer Struktur magnetischer Domänen erhaltenen Analyseergebnisse ein Laserstrahl auf eine Oberfläche des kornorientierten elektromagnetischen Stahlblechs eingestrahlt wird, das in einer Förderrichtung befördert wird, und dadurch mehrerer Rillen oder thermische Dehnungen gebildet werden, die sich in einer die Förderrichtung schneidenden Richtung erstrecken und in Förderrichtung voneinander beabstandet sind.

11. Verfahren zur Herstellung eines kornorientierten elektromagnetischen Stahlblechs nach Anspruch 10, wobei,
in einem Fall, in dem die Oberfläche des kornorientierten elektromagnetischen Stahlblechs in einen ersten Bereich, in dem eine Breite W einer magnetischen Domäne den Schwellenwert L oder mehr beträgt, und einen zweiten Bereich, in dem die Breite W der magnetischen Domäne kleiner als der Schwellenwert L ist, unterteilt ist, der Schritt zum Bilden von Rillen oder thermischen Dehnungen das Bilden mehrerer Rillen oder thermischer Dehnungen in dem ersten Bereich auf der Grundlage der durch den Schritt zur Analyse einer Struktur magnetischer Domänen erhaltenen Analyseergebnisse aufweist, und
vorausgesetzt, dass
eine festgelegte Länge, die eine Summe idealer Längen jeder der mehreren im ersten Bereich gebildeten Rillen oder thermischen Dehnungen ist, C ist,
eine Länge, die die Summe der Differenzen zwischen den jeweiligen Längen und den jeweiligen idealen Längen derjenigen Rillen oder thermischen Dehnungen unter den mehreren Rillen oder thermischen Dehnungen ist, deren jeweilige Länge kürzer als die Breite des ersten Bereichs an der Position der jeweiligen Rille oder thermischen Dehnung in einer zur Einstrahlungsrichtung des Laserstrahls parallelen Richtung ist, D ist,
eine Länge, die die Summe der Differenzen zwischen den jeweiligen Längen und den jeweiligen idealen Längen derjenigen Rillen oder thermischen Dehnungen unter den mehreren Rillen oder thermischen Dehnungen ist, deren jeweilige Länge länger als die Breite des ersten Bereichs an der Position der jeweiligen Rille oder thermischen Dehnung in einer zur Einstrahlungsrichtung des Laserstrahls parallelen Richtung ist, E ist, und ein zulässiger Längenanteil, der der festgelegten Länge C der mehreren Rillen oder thermischen Dehnungen entspricht, R ist,
im Schritt zum Bilden der Rillen oder thermischen Dehnungen die mehreren Rillen oder thermischen Dehnungen, die die folgende Formel (1) erfüllen, im ersten Bereich gebildet werden, indem der Laserstrahl auf der Grundlage der Analyseergebnisse gesteuert wird. $\left(D+E\right) / C < R$ (1)

12. Kornorientiertes elektromagnetisches Stahlblech, wobei
das kornorientierte elektromagnetische Stahlblech durch das Verfahren zur Herstellung eines kornorientierten elektromagnetischen Stahlblechs nach Anspruch 10 hergestellt wird, und
in einem Fall, in dem eine Oberfläche des kornorientierten elektromagnetischen Stahlblechs in einen ersten Bereich, in dem die Breite W einer magnetischen Domäne des kornorientierten elektromagnetischen Stahlblechs den Schwellenwert L oder mehr beträgt, und einen zweiten Bereich, in dem die Breite W der magnetischen Domäne des kornorientierten elektromagnetischen Stahlblechs kleiner als der Schwellenwert L ist, unterteilt ist, die Oberfläche des kornorientierten elektromagnetischen Stahlblechs mehrere Rillen oder thermische Dehnungen aufweist, die in dem ersten Bereich ausgebildet sind, und
vorausgesetzt, dass
eine festgelegte Länge, die eine Summe idealer Längen jeder der mehreren im ersten Bereich gebildeten Rillen oder thermischen Dehnungen ist, C ist,
eine Länge, die die Summe der Differenzen zwischen den jeweiligen Längen und den jeweiligen idealen Längen derjenigen Rillen oder thermischen Dehnungen unter den mehreren Rillen oder thermischen Dehnungen ist, deren jeweilige Länge kürzer als die Breite des ersten Bereichs an der Position der jeweiligen Rille oder thermischen Dehnung in einer zur Einstrahlungsrichtung des Laserstrahls parallelen Richtung ist, D ist,
eine Länge, die die Summe der Differenzen zwischen den jeweiligen Längen und den jeweiligen idealen Längen derjenigen Rillen oder thermischen Dehnungen unter den mehreren Rillen oder thermischen Dehnungen ist, deren jeweilige Länge länger als die Breite des ersten Bereichs an der Position der jeweiligen Rille oder thermischen Dehnung in einer zur Einstrahlungsrichtung des Laserstrahls parallelen Richtung ist, E ist, und ein zulässiger Längenanteil, der der festgelegten Länge C der mehreren Rillen oder thermischen Dehnungen entspricht, R ist,
die mehreren Rillen oder thermischen Dehnungen, die die folgende Formel (1) erfüllen, im ersten Bereich gebildet werden: $\left(D+E\right) / C < R$ (1)

13. Eisenkern, der unter Verwendung des kornorientierten elektromagnetischen Stahlblechs nach Anspruch 12 hergestellt ist.

## Revendications

1. Dispositif d'analyse de structure de domaine magnétique (10), comprenant :
une section d'acquisition d'image de domaine magnétique (12) acquérant une image de domaine magnétique (50) par imagerie d'une tôle d'acier électromagnétique à grains orientés (40) ; et
une section de mesure de largeur de domaine magnétique (16) mesurant la largeur d'un domaine magnétique de la feuille d'acier électromagnétique à grains orientés sur la base de l'image de domaine magnétique,
où ladite section de mesure de largeur de domaine magnétique
génère une pluralité de noyaux de filtre (24) de différentes dimensions spatiales par multiplication d'un filtre de Gabor unidimensionnel complexe par A dans une direction spatiale correspondant à une direction orthogonale à une direction de laminage de la tôle d'acier électromagnétique à grains orientés, et par 1/A dans une direction d'amplitude,
applique la pluralité de noyaux de filtre respectifs à l'image de domaine magnétique, et calcule une valeur absolue de sortie de filtre (28) par noyau de filtre, et
déduit la largeur du domaine magnétique de la tôle d'acier électromagnétique à grains orientés sur la base de la dimension spatiale du noyau de filtre dont la valeur absolue est maximale parmi la pluralité de noyaux de filtre.

2. Dispositif d'analyse de structure de domaine magnétique selon la revendication 1, comprenant une section de mesure d'orientation de domaine magnétique mesurant l'orientation d'un domaine magnétique de la tôle d'acier électromagnétique à grains orientés sur la base de l'image de domaine magnétique,
où la section de mesure d'orientation de domaine magnétique
génère une pluralité d'ensembles de noyaux de filtre différenciés par différentiation de fonctions gaussiennes bidimensionnelles de différentes dimensions spatiales dans une direction X correspondant à la direction orthogonale à la direction de laminage de la tôle d'acier électromagnétique à grains orientés, et dans une direction Y correspondant à la direction de laminage de la tôle d'acier électromagnétique à grains orientés, pour chacune des fonctions gaussiennes bidimensionnelles,
applique la pluralité d'ensembles de noyaux de filtre différenciés respectifs à l'image de domaine magnétique, et calcule les racines carrées des sommes des carrés de sorties de filtre respectives des noyaux de filtre différenciés de la pluralité d'ensembles, et
déduit l'orientation du domaine magnétique de la tôle d'acier électromagnétique à grains orientés sur la base des sorties de filtre respectives des noyaux de filtre différenciés de l'ensemble présentant la racine carrée maximale de la somme des carrés, parmi la pluralité d'ensembles de noyaux de filtre différenciés.

3. Dispositif d'analyse de structure de domaine magnétique selon la revendication 2, comprenant une section de correction de largeur de domaine magnétique, corrigeant la largeur du domaine magnétique de la tôle d'acier électromagnétique à grains orientés, mesurée par la section de mesure de largeur de domaine magnétique, sur la base de l'orientation du domaine magnétique de la tôle d'acier électromagnétique à grains orientés, mesurée par la section de mesure d'orientation de domaine magnétique.

4. Procédé d'analyse de structure de domaine magnétique, comprenant :
une étape d'acquisition d'image de domaine magnétique consistant à acquérir une image de domaine magnétique par imagerie d'une tôle d'acier électromagnétique à grains orientés ; et
une étape de mesure de largeur de domaine magnétique consistant à mesurer la largeur d'un domaine magnétique sur la base de l'image de domaine magnétique,
où l'étape de mesure de largeur de domaine magnétique
génère une pluralité de noyaux de filtre de différentes dimensions spatiales par multiplication d'un filtre de Gabor unidimensionnel complexe par A dans une direction spatiale correspondant à une direction orthogonale à la direction de laminage de la tôle d'acier électromagnétique à grains orientés, et par 1/A dans une direction d'amplitude,
applique la pluralité de noyaux de filtre respectifs à l'image de domaine magnétique, et calcule une valeur absolue de la sortie de filtre par noyau de filtre, et
déduit la largeur du domaine magnétique de la tôle d'acier électromagnétique à grains orientés sur la base de la dimension spatiale du noyau de filtre dont la valeur absolue est maximale parmi la pluralité de noyaux de filtre.

5. Procédé d'analyse de structure de domaine magnétique selon la revendication 4, comprenant une étape de mesure d'orientation de domaine magnétique consistant à mesurer l'orientation d'un domaine magnétique de la tôle d'acier électromagnétique à grains orientés sur la base de l'image de domaine magnétique,
où l'étape de mesure d'orientation de domaine magnétique
génère une pluralité d'ensembles de noyaux de filtre différenciés par différentiation de fonctions gaussiennes bidimensionnelles de différentes dimensions spatiales dans une direction X correspondant à la direction orthogonale à la direction de laminage de la tôle d'acier électromagnétique à grains orientés et dans une direction Y correspondant à la direction de laminage de la tôle d'acier électromagnétique à grains orientés, pour chacune des fonctions gaussiennes bidimensionnelles,
applique la pluralité d'ensembles de noyaux de filtre différenciés respectifs à l'image de domaine magnétique, et calcule les racines carrées des sommes des carrés de sorties de filtre respectives des noyaux de filtre différenciés de la pluralité d'ensembles, et
déduit l'orientation du domaine magnétique de la tôle d'acier électromagnétique à grains orientés sur la base des sorties de filtre respectives des noyaux de filtre différenciés de l'ensemble présentant la racine carrée maximale de la somme des carrés, parmi la pluralité d'ensembles de noyaux de filtre différenciés.

6. Procédé d'analyse de structure de domaine magnétique selon la revendication 5, comprenant une étape de correction de largeur du domaine magnétique consistant à corriger la largeur du domaine magnétique de la tôle d'acier électromagnétique à grains orientés mesurée lors de l'étape de mesure de largeur de domaine magnétique, sur la base de l'orientation du domaine magnétique de la tôle d'acier électromagnétique à grains orientés mesurée lors de l'étape de mesure d'orientation de domaine magnétique.

7. Programme entraînant l'exécution de traitements par un ordinateur, lesdits traitements comprenant :
une étape d'acquisition d'image de domaine magnétique consistant à acquérir une image de domaine magnétique par imagerie d'une tôle d'acier électromagnétique à grains orientés ; et
une étape de mesure de largeur de domaine magnétique consistant à mesurer la largeur d'un domaine magnétique sur la base de l'image de domaine magnétique,
où l'étape de mesure de largeur de domaine magnétique
génère une pluralité de noyaux de filtre de différentes dimensions spatiales par multiplication d'un filtre de Gabor unidimensionnel complexe par A dans une direction spatiale correspondant à une direction orthogonale à la direction de laminage de la tôle d'acier électromagnétique à grains orientés, et par 1/A dans une direction d'amplitude,
applique la pluralité de noyaux de filtre respectifs à l'image de domaine magnétique, et calcule une valeur absolue de sortie de filtre par noyau de filtre, et
déduit la largeur du domaine magnétique de la tôle d'acier électromagnétique à grains orientés sur la base de la dimension spatiale du noyau de filtre dont la valeur absolue est maximale parmi la pluralité de noyaux de filtre.

8. Programme selon la revendication 7, où les traitements comprennent une étape de mesure d'orientation de domaine magnétique consistant à mesurer l'orientation d'un domaine magnétique de la tôle d'acier électromagnétique à grains orientés sur la base de l'image de domaine magnétique,
où l'étape de mesure d'orientation de domaine magnétique
génère une pluralité d'ensembles de noyaux de filtre différenciés par différentiation de fonctions gaussiennes bidimensionnelles de différentes dimensions spatiales dans une direction X correspondant à la direction orthogonale à la direction de laminage de la tôle d'acier électromagnétique à grains orientés et dans une direction Y correspondant à la direction de laminage de la tôle d'acier électromagnétique à grains orientés, pour chacune des fonctions gaussiennes bidimensionnelles,
applique la pluralité d'ensembles de noyaux de filtre différenciés respectifs à l'image de domaine magnétique, et calcule les racines carrées des sommes des carrés de sorties de filtre respectives des noyaux de filtre différenciés de la pluralité d'ensembles, et
déduit l'orientation du domaine magnétique de la tôle d'acier électromagnétique à grains orientés sur la base des sorties de filtre respectives des noyaux de filtre différenciés de l'ensemble présentant la racine carrée maximale de la somme des carrés, parmi la pluralité d'ensembles de noyaux de filtre différenciés.

9. Programme selon la revendication 8, où les traitements comprennent une étape de correction de largeur de domaine magnétique consistant à corriger la largeur du domaine magnétique de la tôle d'acier électromagnétique à grains orientés mesurée lors de l'étape de mesure de largeur de domaine magnétique, sur la base de l'orientation du domaine magnétique de la tôle d'acier électromagnétique à grains orientés mesurée lors de l'étape de mesure d'orientation de domaine magnétique.

10. Procédé de fabrication d'une tôle d'acier électromagnétique à grains orientés, comprenant :
une étape d'analyse de structure de domaine magnétique consistant à effectuer une analyse de la structure de domaine magnétique, comprenant le calcul de la largeur d'un domaine magnétique d'une tôle d'acier électromagnétique à grains orientés au moyen du procédé d'analyse de structure de domaine magnétique selon l'une des revendications 4 à 6 ; et
une étape de formation de rainures ou de déformations thermiques consistant, sur la base de résultats d'analyse obtenus lors de l'étape d'analyse de la structure de domaine magnétique, à irradier un faisceau laser sur une surface de la tôle d'acier électromagnétique à grains orientés transportée dans une direction de transport, et à former ainsi une pluralité de rainures ou de déformations thermiques s'étendant dans une direction croisant la direction de transport, à intervalles dans la direction de transport.

11. Procédé de fabrication d'une tôle d'acier électromagnétique à grains orientés selon la revendication 10, où,
dans le cas où la surface de la tôle d'acier électromagnétique à grains orientés est divisée en une première zone où la largeur W d'un domaine magnétique est égale ou supérieure à une valeur seuil L et en une deuxième zone où la largeur W du domaine magnétique est inférieure à la valeur seuil L, l'étape de formation de rainures ou de déformations thermiques comprend la formation d'une pluralité de rainures ou de déformations thermiques dans la première zone sur la base des résultats d'analyse obtenus lors de l'étape d'analyse de la structure de domaine magnétique, et,
étant donné
qu'une longueur définie correspondant à la somme des longueurs idéales de chaque rainure ou déformation de la pluralité de rainures ou de déformations thermiques formées dans la première zone est une longueur C,
qu'une longueur correspondant à la somme des différences entre les longueurs et les longueurs idéales de chaque rainure ou déformation de la pluralité de rainures ou de déformations thermiques, dont la longueur est inférieure à une largeur de la première zone aux emplacements des rainures ou déformations thermiques respectives dans une direction parallèle à la direction d'irradiation par le faisceau laser, est une longueur D, qu'une longueur correspondant à la somme des différences entre les longueurs et les longueurs idéales de chaque rainure ou déformation de la pluralité de rainures ou de déformations thermiques dont la longueur est supérieure à la largeur de la première zone, aux emplacements des rainures ou déformations thermiques respectives dans une direction parallèle à la direction d'irradiation par le faisceau laser est une longueur E, qu'une proportion de longueur admissible correspondant à la longueur C définie de la pluralité de rainures ou de déformations thermiques est une proportion R,
lors de l'étape de formation de rainures ou de contraintes thermiques, la pluralité de rainures ou de contraintes thermiques satisfaisant à la formule (1) suivante est formée dans la première zone par commande du faisceau laser sur la base des résultats d'analyse. $\left(D+E\right) / C < R$ (1)

12. Tôle d'acier électromagnétique à grains orientés, où
ladite tôle d'acier électromagnétique à grains orientés est fabriquée conformément au procédé de fabrication d'une tôle d'acier électromagnétique à grains orientés selon la revendication 10, et,
dans le cas où une surface de la tôle d'acier électromagnétique à grains orientés est divisée en une première zone où la largeur W d'un domaine magnétique est égale ou supérieure à une valeur seuil L et en une deuxième zone où la largeur W du domaine magnétique est inférieure à la valeur seuil L, la surface de la tôle d'acier électromagnétique à grains orientés comprend une pluralité de rainures ou de déformations thermiques formées dans la première zone, et,
étant donné
qu'une longueur définie correspondant à la somme des longueurs idéales de chaque rainure ou déformation de la pluralité de rainures ou de déformations thermiques formées dans la première zone est une longueur C,
qu'une longueur correspondant à la somme des différences entre les longueurs et les longueurs idéales de chaque rainure ou déformation de la pluralité de rainures ou de déformations thermiques, dont la longueur est inférieure à une largeur de la première zone aux emplacements des rainures ou déformations thermiques respectives dans une direction parallèle à la direction d'irradiation par le faisceau laser, est une longueur D, qu'une longueur correspondant à la somme des différences entre les longueurs et les longueurs idéales de chaque rainure ou déformation de la pluralité de rainures ou de déformations thermiques dont la longueur est supérieure à la largeur de la première zone aux emplacements des rainures ou déformations thermiques respectives dans une direction parallèle à la direction d'irradiation par le faisceau laser, est une longueur E, qu'une proportion de longueur admissible correspondant à la longueur C définie de la pluralité de rainures ou de déformations thermiques est une proportion R,
la pluralité de rainures ou de déformations thermiques satisfaisant à la formule (1) suivante est formée dans la première zone. $\left(D+E\right) / C < R$ (1)

13. Noyau de fer fabriqué au moyen de la tôle d'acier électromagnétique à grains orientés selon la revendication 12.
